# EUROPEAN PATENT APPLICATION

(11) **EP 2 077 577 A1**
(43) Date of publication of application: **08.07.2009**
(21) Application number: 07807566.0
(22) Date of filing: 19.09.2007
(51) Int. Cl.: H01L 21/3065

(54) **SILICON STRUCTURE WITH OPENING HAVING HIGH ASPECT RATIO, METHOD FOR MANUFACTURING THE SILICON STRUCTURE, APPARATUS FOR MANUFACTURING THE SILICON STRUCTURE, PROGRAM FOR MANUFACTURING THE SILICON STRUCTURE, AND METHOD FOR MANUFACTURING ETCHING MASK FOR THE SILICON STRUCTURE**

(30) Priority: 22.11.2006 JP 2006315472; 22.11.2006 JP 2006315479
(71) Applicant: Sumitomo Precision Products Co., Ltd., Hyogo 660-0891 (JP)
(72) Inventor: TANAKA, Masahiko, Amagasaki-shi Hyogo 660-0891 (JP); OISHI, Akimitsu, Amagasaki-shi Hyogo 660-0891 (JP)
(74) Representative: Treeby, Philip David William
(86) International application number: PCT/JP2007/068197
(87) International publication number: WO 2008/062600

(57) **Abstract**

Provided are a silicon structure having an opening which has a high aspect ratio and an etching mask for forming the silicon structure. A step of performing hole etching or trench etching of silicon so as to substantially expose a portion of at least a bottom surface of etched silicon and a step of forming a silicon oxide film by a CVD method on the silicon structure formed by the step of performing the hole etching or the trench etching are conducted. Thereafter, a step of exposing the formed silicon oxide film to a gas containing a hydrogen fluoride vapor is conducted. Further, the above-mentioned step of performing the hole etching or the trench etching is conducted again.

## Description

### TECHNICAL FIELD

The present invention relates to a silicon structure having an opening which has a high aspect ratio; a method for manufacturing the same; a system for manufacturing the same; and a program for manufacturing the same; and a method for manufacturing an etching mask for the silicon structure having an opening which has a high aspect ratio.

### BACKGROUND ART

Technical fields in which MEMS (Micro Electro Mechanical Systems) devices utilizing silicon are applied have been rapidly evolving and in recent years, have been applied not only to micro turbines and sensors but also in information and communication fields and medical fields. One of principal element technologies which underlie this MEMS technology is anisotropic dry etching of silicon. It can be said that development of this element technology plays supporting roles in development of the MEMS technology. Over the last several years, the technology of the anisotropic dry etching of the silicon has made dramatic progress. Despite the dramatic progress, however, a demand for formation of an opening which has a high aspect ratio remains unflagging. For example, it has already been known that manufacturing a silicon structure having an opening which has a high aspect ratio enables a device such as a semiconductor acceleration sensor to be manufactured.

As one means for solving a technical problem in the manufacturing of the silicon structure having an opening which has a high aspect ratio, a technology in which a gas for anisotropic etching and a gas for polymer formation are alternately rendered in a plasma state has been disclosed (refer to Patent Document 1). In this method, however, a sidewall protection film in the vicinity of a topmost surface of a silicon substrate (hereinafter, also referred to as a substrate topmost surface) which has not been etched is destroyed due to oblique incidence of ions or the like, thereby incurring a problem that a width of the opening is made wider than its initial width or a surface of the sidewall is roughened.

As a means for solving the problem as to the sidewall, a technology in which formation of an oxide film or a nitride film is conducted by plasma irradiation of an oxygen gas or a nitrogen gas, instead of the formation of the protection film by using the gas for the polymer formation, has been disclosed (refer to Patent Document 2). This technology aims to prevent corrosion of the sidewall through forming a protection film of the oxide film or the like on a sidewall and a bottom surface of a trench by plasma irradiation of the oxygen gas or the like.

In this method, however, when the silicon is etched in a further deep manner, it is required to first remove a silicon oxide film (hereinafter, also simply referred to as an oxide film) of the bottom surface, which is a barrier to the etching. In such as case, as described in the above-mentioned Patent Document, even when the silicon oxide film is used as an etching mask, it is unavoidable for this silicon oxide film to be etched. When thereafter, the anisotropic dry etching of the silicon is further performed, the mask is continuously consumed. This phenomenon occurs, regardless of whether the mask is a resist or the silicon oxide film, and needless to say, the consumption is drastic when the resist is used. Accordingly, if the above technology is employed, a depth of the silicon which can be etched and an aspect ratio are determined by an initial thickness of an etching mask. Thus, in a case where a particularly high aspect ratio is demanded, the above technology cannot be applied.

As described above, when a silicon structure having an opening which has a high aspect ratio is manufactured, merely solving the problem of the corrosion on the sidewall is not enough but it is required to take into account depletion of the mask. In a case where an aspect ratio is greater than or equal to 40 when trench etching is performed, or an aspect ratio is greater than or equal to 20 when hole etching is performed, the above-described problems particularly emerge.
Patent Document 1: U.S. Pat. No. 5,501,893
Patent Document 2: Japanese Patent Application Laid-Open Publication No. 2002-367960

### DISCLOSURE OF THE INVENTION

### PROBLEMS TO BE SOLVED BY THE INVENTION

As described above, strongly desired is a means that accomplishes not only the prevention of corrosion on the etched portion of the sidewall but also the prevention of depletion of the mask when an opening which has a high aspect ratio is formed on a silicon material.

As means for solving the problem of the depletion of the mask, for example, it can be considered that a sufficient thickness of the etching mask is initially provided. However, it is not easy to steepen tapered shapes of mask edges of a thick etching mask all over a substrate. In order to obtain the high aspect ratio, it is preferable to utilize, as the etching mask, a silicon oxide film with a high etching resistance. However, if this silicon oxide film is formed so as to be thick, it is extremely difficult to form a mask which attains a sufficient selectivity when anisotropic etching of the oxide film itself is performed.

### SOLUTION TO THE PROBLEMS

Through solving such technical problems, the present invention allows manufacture of a silicon structure having an opening which has a high aspect ratio without depleting an etching mask, thus contributing to further enhancement of performance of anisotropic dry etching of silicon. The inventors first focused attention on a side effect that is the depletion of the etching mask, which is invariably attendant in a case where anisotropic etching of the silicon structure is additionally performed, even though the silicon oxide film is effective as a protection film which prevents the corrosion of a sidewall. On the other hand, the inventors had grasped that even when plasma etching is performed as disclosed in the above-mentioned Patent Document 1, the protection film which is formed on a sidewall surface in the vicinity of a topmost surface, that is, in the vicinity of an entrance of the opening and is considered to be of a polymer is not removed until a certain level of an aspect ratio is attained. Hence, the inventors thought that at a stage where the silicon structure has been etched such that a predetermined aspect ratio is attained, protection of the sidewall and formation or reproduction of the etching mask can be concurrently achieved by instead utilizing a characteristic which has so far been deemed as a shortcoming of a CVD (chemical vapor deposition) method, namely, non-uniformity of a film thickness. The present invention was created based on the above-described point of view.

One method according to the present invention for manufacturing a silicon structure having an opening which has a high aspect ratio comprises the steps of: performing hole etching or trench etching of silicon so as to substantially expose a portion of at least a bottom surface of etched silicon; forming a silicon oxide film by a CVD method on the silicon structure formed by the step of performing the hole etching or the trench etching; exposing the silicon oxide film to a gas containing a hydrogen fluoride vapor after the step of forming the silicon oxide film; and performing again the above-mentioned hole etching or trench etching after the step of exposing the silicon oxide film to the gas containing the hydrogen fluoride vapor.

According to this manufacturing method, an oxide film is formed by the CVD method on silicon which has been etched by the hole etching or the trench etching and whose portion of at least a bottom surface is exposed. This forms a thick oxide film on the substrate topmost surface and the sidewall surface in the vicinity of the substrate topmost surface, as compared with the oxide film on the bottom surface and the sidewall in the vicinity of the bottom surface. Consequently, when thereafter, the silicon structure is exposed to the gas containing the hydrogen fluoride vapor, the silicon oxide film on the bottom surface and the sidewall surface in the vicinity of the bottom surface is removed earlier than the oxide film on the substrate topmost surface and the sidewall surface in the vicinity of the substrate topmost surface, whereby the oxide film remains at least on the substrate topmost surface and the sidewall surface in the vicinity of the substrate topmost surface. As a result, the remaining oxide film serves not only a function of protecting the sidewall surface in the vicinity of the topmost surface but also as a mask for the subsequent additional trench etching or hole etching. When the mask used upon the initial hole etching or trench etching is a metal mask, a silicon oxide film, a silicon nitride film, or the like, a thickness of the oxide film is added thereto in the CVD, thereby allowing the mask to be reproduced after the depletion thereof caused by the etching process. As a result, the etching of the silicon can be repeatedly performed while the depletion of the mask and roughening of the inner wall surface are prevented, thereby enabling the manufacture of the silicon structure having an opening which has a high aspect ratio.

Furthermore, it also deserves special mention that in the above-described process of forming the silicon oxide film by the CVD method, since the oxide film is formed in accordance with the existing etching shape, the oxide film is formed as the mask for the subsequent silicon etching without alignment. In other words, this achieves the so-called self-alignment technology.

Here, with respect to the silicon structure, as a starting material, which has undergone the hole etching or the trench etching, a manufacturing method thereof is not limited. The silicon structure may be formed by, for example, the heretofore known laser ablation method or reactive ion etching (hereinafter, also referred to as RIE) method using a metal mask, etc.

Another method according to the present invention for manufacturing a silicon structure having an opening which has a high aspect ratio comprises the steps of: performing hole etching or trench etching of silicon by plasma generated by alternately rendering an etching gas and an organic deposit forming gas in a plasma state or generated by mixing the etching gas and the organic deposit forming gas; etching, by plasma generated by using oxygen or an oxygen-containing gas, an organic deposit on the silicon structure formed by the step of performing the hole etching or the trench etching; forming a silicon oxide film on the silicon structure by a CVD method after the step of etching the organic deposit; exposing the silicon oxide film to a gas containing a hydrogen fluoride vapor after the step of forming the silicon oxide film; and performing again the above-mentioned hole etching or trench etching after the step of exposing the silicon oxide film to the gas containing the hydrogen fluoride vapor.

According to this manufacturing method, first, the organic deposit on the etched portion of the inner wall of the silicon structure formed by the hole etching or the trench etching, more specifically, on the sidewall surface and the bottom surface and the resist film in a case of initially using the resist mask are removed; the silicon is exposed; and thereafter, the oxide film is formed by the CVD method. This forms a thick oxide film on the substrate topmost surface and the sidewall surface in the vicinity of the substrate topmost surface, as compared with the oxide film on the bottom surface and the sidewall in the vicinity of the bottom surface. Consequently, when thereafter, the silicon structure is exposed to the gas containing the hydrogen fluoride vapor, the silicon oxide film on the bottom surface and the sidewall surface in the vicinity of the bottom surface is removed earlier than the oxide film on the substrate topmost surface and the sidewall surface in the vicinity of the substrate topmost surface, whereby the oxide film on the substrate topmost surface and the sidewall surface in the vicinity of the substrate topmost surface remains. As a result, the remaining oxide film serves not only a function of protecting the sidewall surface in the vicinity of the topmost surface but also as a mask for the subsequent additional trench etching or hole etching. In other words, when the initial mask is the resist mask, the mask can be converted to a silicon oxide film mask having further strong etching resistance by applying the present invention. On the other hand, when the initial mask used upon the hole etching or the trench etching is a metal mask, a silicon oxide film, a silicon nitride film, or the like, a thickness of the oxide film is added thereto in the CVD, thereby allowing the mask to be reproduced after the depletion thereof caused by the etching process. As a result, the etching of the silicon can be repeatedly performed while the depletion of the mask and roughening of the inner wall surface are prevented, thereby enabling the manufacture of the silicon structure having an opening which has a high aspect ratio.

Specifically, first, the silicon structure which has undergone the hole etching or the trench etching is subjected to the above-described steps of: etching the organic deposit by using the oxygen plasma or the like; forming the silicon oxide film by the CVD method; and the exposure to the gas containing the hydrogen fluoride vapor, and thereafter, the hole etching or the trench etching of the silicon is additionally performed. Thereafter, before the oxide film of the etching mask or the oxide film on the sidewall surface in the vicinity of the substrate topmost surface is removed during the etching of the silicon, the etching process is once stopped and thereafter, the above-described step of etching the organic deposit, the step of forming the oxide film, and the step of the exposure are conducted, thereby restoring a thickness of the etching mask and a thickness of the oxide film on the sidewall surface in the vicinity of the substrate topmost surface. Consequently, further additional hole etching or trench etching of the silicon can be continued, thereby enabling formation of the opening in the silicon structure, which has the higher aspect ratio.

Furthermore, it also deserves special mention that in the above-described process of forming the silicon oxide film by the CVD method, since the oxide film is formed in accordance with the existing etching shape, the oxide film is formed as the mask for the subsequent silicon etching without alignment. In other words, this achieves the so-called self-alignment technology.

Each of the above-described silicon structure manufacturing methods according to the present invention has an advantage that the resist mask which has a lower etching resistance than that of the silicon oxide film or the silicon nitride film can be used in the initial etching of the silicon. If it is necessary to use the mask of the silicon oxide film or the like in the initial etching, there arises a detriment that a patterning process for forming the mask is separately required.

One system according to the present invention for manufacturing a silicon structure having an opening which has a high aspect ratio comprises: a chamber for performing hole etching or trench etching of silicon so as to substantially expose a portion of at least a bottom surface of etched silicon; a chamber for forming a silicon oxide film by a CVD method on the silicon structure formed by performing the hole etching or the trench etching; a chamber for exposing the silicon oxide film to a gas containing a hydrogen fluoride vapor after forming the silicon oxide film; and transfer means for transferring the silicon structure to each of the chambers without exposing the silicon structure to outside air.

By using this manufacturing system, not only in a case where a silicon substrate which has not been subjected to any etching is used as a starting material but also even in a case where a silicon structure which has already been subjected to the hole etching or the trench etching is used as the starting material, the silicon structure having an opening which has a high aspect ratio can be eventually manufactured.

Even in each of the above-mentioned cases, by using the chamber for forming the silicon oxide film, a thick oxide film is formed on the substrate topmost surface and the sidewall surface in the vicinity of the substrate topmost surface, as compared with the oxide film on the bottom surface and the sidewall in the vicinity of the bottom surface. Consequently, when thereafter, the silicon structure is exposed to the gas containing the hydrogen fluoride vapor, the silicon oxide film on the bottom surface and the sidewall surface in the vicinity of the bottom surface is removed earlier than the oxide film on the substrate topmost surface and the sidewall surface in the vicinity of the substrate topmost surface, whereby the oxide film remains on the substrate topmost surface and the sidewall surface in the vicinity of the substrate topmost surface. As a result, the remaining oxide film serves not only a function of protecting the sidewall surface in the vicinity of the topmost surface but also as a mask for the subsequent additional trench etching or hole etching. This achieves the so-called self-alignment technology. Accordingly, by using this manufacturing system, the etching of the silicon can be repeatedly performed while the depletion of the mask and roughening of the inner wall surface are prevented, thereby enabling the manufacture of the silicon structure having an opening which has a high aspect ratio. Further, because the silicon structure which moves between the respective chambers is not exposed to outside air, the silicon structure is not oxidized by an influence of moisture or the like of the outside air.

Here, when the mask used upon the hole etching or the trench etching is a metal mask, a silicon oxide film, a silicon nitride film, or the like, a thickness of the oxide film is added thereto in the CVD, thereby allowing the mask to be reproduced after the depletion thereof caused by the etching process.

In addition, in a case where a starting material is a silicon structure which has already been subjected to the hole etching or the trench etching, a manufacturing method thereof is not limited. The silicon whose etched portion of the bottom surface is substantially exposed may be formed by, for example, the heretofore known laser ablation method or reactive ion etching (RIE) method using a metal mask, etc.

Another system according to the present invention for manufacturing a silicon structure having an opening which has a high aspect ratio comprises: a chamber for performing hole etching or trench etching of silicon by plasma generated by alternately rendering an etching gas and an organic deposit forming gas in a plasma state or generated by mixing the etching gas and the organic deposit forming gas; a chamber for etching, by plasma generated by using oxygen or an oxygen-containing gas, an organic deposit on the silicon structure formed by performing the hole etching or the trench etching; a chamber for forming a silicon oxide film on the silicon structure by a CVD method after etching the organic deposit; a chamber for exposing the silicon oxide film to a gas containing a hydrogen fluoride vapor after forming the silicon oxide film; and transfer means for transferring the silicon structure to each of the above-mentioned chambers without exposing the silicon structure to outside air.

By using this manufacturing system, not only in a case where a silicon substrate which has not been subjected to any etching is used as a starting material but also even in a case where a silicon structure which has already been subjected to the hole etching or the trench etching is used as the starting material, the silicon structure having an opening which has a high aspect ratio can be eventually manufactured.

In the former case, the silicon substrate is initially subjected to the hole etching or trench etching by the plasma generated by alternately rendering the etching gas and the organic deposit forming gas in the plasma state or generated by mixing the etching gas and the organic deposit forming gas. Thereafter, the organic deposit on the silicon structure which has been subjected to the above-mentioned hole etching or trench etching is removed by etching and thereafter, the oxide film is formed by the CVD method on the silicon structure. Even in each of the above-mentioned cases, by using the chamber for forming the silicon oxide film, a thick oxide film is formed on the substrate topmost surface and the sidewall surface in the vicinity of the substrate topmost surface, as compared with the oxide film on the bottom surface and the sidewall in the vicinity of the bottom surface. Consequently, when thereafter, the silicon structure is exposed to the gas containing the hydrogen fluoride vapor, the silicon oxide film on the bottom surface and the sidewall surface in the vicinity of the bottom surface is removed earlier than the oxide film on the substrate topmost surface and the sidewall surface in the vicinity of the substrate topmost surface, whereby the oxide film on the substrate topmost surface and the sidewall surface in the vicinity of the substrate topmost surface remains. As a result, the remaining oxide film serves not only a function of protecting the sidewall surface in the vicinity of the topmost surface but also as a mask for the subsequent additional trench etching or hole etching. This achieves the so-called self-alignment technology. Accordingly, by using this manufacturing system, the etching of the silicon can be repeatedly performed while the depletion of the mask and roughening of the inner wall surface are prevented, thereby enabling the manufacture of the silicon structure having an opening which has a high aspect ratio.

Further, because the silicon structure which moves between the respective chambers is not exposed to outside air, the silicon structure is not oxidized by an influence of moisture or the like of the outside air. In addition, if the silicon structure which has been subjected to the dry etching by employing the above-described method is exposed to the outside air, the organic deposit on the etched portion of the sidewall surface or the bottom surface changes in quality, whereby the removal of the organic deposit by the subsequent etching may be made impossible. Accordingly, the prevention of the exposure of the silicon structure to the outside air brings about an advantage that such a problem is not caused. When the mask used upon the hole etching or the trench etching is a metal mask, a silicon oxide film, a silicon nitride film, or the like, a thickness of the oxide film is added thereto in the CVD, thereby allowing the mask to be reproduced after the depletion thereof caused by the etching process.

In addition, by using this manufacturing system, even when the initial mask is the resist mask, the silicon structure having an opening which has a high aspect ratio can be eventually formed in a comparatively easy manner, though it is extremely difficult to achieve this by using the resist mask. In other words, the silicon structure which has been subjected to the hole etching or the trench etching is formed by using the resist mask, and the silicon structure having an opening which has a high aspect ratio can be formed even when the silicon structure has the residues of the resist mask. If it is necessary to use the mask of the silicon oxide film from the beginning, an extra patterning process for forming the mask is required. Therefore, a great advantage is that the resist mask can be initially used.

In addition, the above-described chamber for forming the silicon structure which has been subjected to the hole etching or the trench etching is allowed to be the same as the chamber for etching the organic deposit. Thus, by conducting a plurality of processes in the same chamber, an advantage that an overall processing time can be shortened is attained.

In addition, it is preferable that the controllers for continuously conducting the above-described steps of: performing the hole etching or the trench etching of the silicon; forming the silicon oxide film; the exposure to the gas containing the hydrogen fluoride vapor; and etching the organic deposit when needed, with the transfer steps interposed therebetween, are provided. This can prevent a natural oxide film from being formed by moisture or the like and can achieve an opening which has a high aspect ratio, attaining further fine reproducibility.

One program according to the present invention for manufacturing a silicon structure having an opening which has a high aspect ratio comprises the steps of: performing hole etching or trench etching of silicon so as to substantially expose a portion of at least a bottom surface of etched silicon; forming a silicon oxide film by a CVD method on the silicon structure formed by the step of performing the hole etching or the trench etching; exposing the silicon oxide film to a gas containing a hydrogen fluoride vapor after the step of forming the silicon oxide film; and performing again the above-mentioned hole etching or trench etching after the step of exposing the silicon oxide film to the gas containing the hydrogen fluoride vapor.

By executing this program, an oxide film is first formed by the CVD method on silicon which has been etched by the hole etching or the trench etching and whose portion of at least a bottom surface is exposed, whereby a thick oxide film is formed on the substrate topmost surface and the sidewall surface in the vicinity of the substrate topmost surface, as compared with the oxide film on the bottom surface and the sidewall in the vicinity of the bottom surface. Thereafter, when the silicon structure is exposed to the gas containing the hydrogen fluoride vapor, the silicon oxide film on the bottom surface and the sidewall surface in the vicinity of the bottom surface is removed earlier than the oxide film on the substrate topmost surface and the sidewall surface in the vicinity of the substrate topmost surface, whereby the oxide film on the substrate topmost surface and the sidewall surface in the vicinity of the substrate topmost surface remains. As a result, the remaining oxide film serves not only a function of protecting the sidewall surface in the vicinity of the topmost surface but also as a mask for the subsequent additional trench etching or hole etching. This achieves the so-called self-alignment technology. Accordingly, by executing this manufacturing program, the etching of the silicon can be repeatedly performed while the depletion of the mask and roughening of the inner wall surface are prevented, thereby enabling the manufacture of the silicon structure having an opening which has a high aspect ratio.

Here, when the initial mask used upon the hole etching or the trench etching is a metal mask, a silicon oxide film, a silicon nitride film, or the like, a thickness of the oxide film is added thereto in the CVD, thereby allowing the mask to be reproduced after the depletion thereof caused by the etching process. Accordingly, an advantage is attained that the etching of the silicon can be repeatedly performed regardless of the kind of the mask. This advantage also contributes to manufacture of the silicon structure having an opening which has a high aspect ratio.

In addition, in a case where a starting material is a silicon structure which has already been subjected to the hole etching or the trench etching, a manufacturing method thereof is not limited. The silicon whose etched portion of the bottom surface is substantially exposed may be formed by, for example, the heretofore known laser ablation method or reactive ion etching (RIE) method using a metal mask, etc.

Another program according to the present invention for manufacturing a silicon structure having an opening which has a high aspect ratio comprises the steps of: performing hole etching or trench etching of silicon by plasma generated by alternately rendering an etching gas and an organic deposit forming gas in a plasma state or generated by mixing the etching gas and the organic deposit forming gas; etching, by plasma generated by using oxygen or an oxygen-containing gas, an organic deposit on the silicon structure formed by the step of performing the hole etching or the trench etching; forming a silicon oxide film on the silicon structure by a CVD method after the step of etching the organic deposit; exposing the silicon oxide film to a gas containing a hydrogen fluoride vapor after the step of forming the silicon oxide film; and performing again the above-mentioned hole etching or trench etching after the step of exposing the silicon oxide film to the gas containing the hydrogen fluoride vapor.

By executing this program, first, the organic deposit on the etched portion of the inner wall of the silicon structure formed by the hole etching or the trench etching, more specifically, on the sidewall surface and the bottom surface and the resist film in a case of initially using the resist mask are removed, and the silicon is exposed. Thereafter, an oxide film is formed by the CVD method and a thick oxide film is formed on the substrate topmost surface and the sidewall surface in the vicinity of the substrate topmost surface, as compared with the oxide film on the bottom surface and the sidewall in the vicinity of the bottom surface. Further thereafter, when the silicon structure is exposed to the gas containing the hydrogen fluoride vapor, the silicon oxide film on the bottom surface and the sidewall surface in the vicinity of the bottom surface is removed earlier than the oxide film on the substrate topmost surface and the sidewall surface in the vicinity of the substrate topmost surface, whereby the oxide film remains on the substrate topmost surface and the sidewall surface in the vicinity of the substrate topmost surface. As a result, the remaining oxide film serves not only a function of protecting the sidewall surface in the vicinity of the topmost surface but also as a mask for the subsequent additional trench etching or hole etching. When the initial mask used upon the hole etching or the trench etching is a metal mask, a silicon oxide film, a silicon nitride film, or the like, a thickness of the oxide film is added thereto in the CVD, thereby allowing the mask to be reproduced after the depletion thereof caused by the etching process. As a result, the etching of the silicon can be repeatedly performed while the depletion of the mask and roughening of the inner wall surface are prevented, thereby enabling the manufacture of the silicon structure having an opening which has a high aspect ratio.

Specifically, first, the silicon structure which has undergone the hole etching or the trench etching is subjected to the above-described steps of: etching the organic deposit by the oxygen plasma or the like; forming the silicon oxide film by the CVD method; and the exposure to the gas containing the hydrogen fluoride vapor, and thereafter, the hole etching or the trench etching of the silicon is additionally performed. Thereafter, before the oxide film of the etching mask or the oxide film on the sidewall surface in the vicinity of the substrate topmost surface is removed upon the etching of the silicon, the etching process is once stopped and thereafter, the above-described steps of: etching the organic deposit; forming the oxide film; and the exposure to the gas containing the hydrogen fluoride vapor are conducted, thereby restoring a thickness of the etching mask and a thickness of the oxide film on the sidewall surface in the vicinity of the substrate topmost surface. Consequently, further additional hole etching or trench etching of the silicon can be continued, thereby enabling formation of the opening, which has the higher aspect ratio, in the silicon structure.

Furthermore, it also deserves special mention that in the above-described process of forming the silicon oxide film by the CVD method, since the oxide film is formed in accordance with the existing etching shape, the oxide film is formed as the mask for the subsequent silicon etching without alignment. In other words, this achieves the so-called self-alignment technology. By using this silicon structure manufacturing program, even when the initial mask is the resist mask, the silicon structure having an opening which has a high aspect ratio can be eventually formed in a comparatively easy manner, though it is extremely difficult to achieve this by using the resist mask.

One method according to the present invention for manufacturing an etching mask for a silicon structure having an opening which has a high aspect ratio comprises the steps of: forming a silicon oxide film by a CVD method on a silicon structure which has undergone etching of a hole or etching of a trench and whose silicon of at least a bottom surface of the hole or the trench is substantially exposed; and exposing the silicon oxide film to a gas containing a hydrogen fluoride vapor after the step of forming the silicon oxide film.

According to this manufacturing method, an oxide film is formed by the CVD method on the silicon structure which has been etched by the hole etching or the trench etching and whose etched portion of at least the bottom surface is substantially exposed. This forms a thick oxide film on the substrate topmost surface and the sidewall surface in the vicinity of the substrate topmost surface, as compared with the oxide film on the bottom surface and the sidewall in the vicinity of the bottom surface. Consequently, when thereafter, the silicon structure is exposed to the gas containing the hydrogen fluoride vapor, the silicon oxide film on the bottom surface and the sidewall surface in the vicinity of the bottom surface is removed earlier than the oxide film on the substrate topmost surface and the sidewall surface in the vicinity of the substrate topmost surface, whereby the oxide film at least on the substrate topmost surface and the sidewall surface in the vicinity of the substrate topmost surface remains. As a result, the remaining oxide film serves not only a function of protecting the sidewall surface in the vicinity of the topmost surface but also as a mask for the subsequent additional trench etching or hole etching. Furthermore, it also deserves special mention that in the above-described process of forming the silicon oxide film by the CVD method, since the oxide film is formed in accordance with the existing etching shape, the oxide film is formed as the mask for the subsequent silicon etching without alignment. In other words, this achieves the so-called self-alignment technology. When the mask used upon the hole etching or the trench etching is a metal mask, a silicon oxide film, a silicon nitride film, or the like, a thickness of the oxide film is added thereto in the CVD, thereby allowing the mask to be reproduced after the depletion thereof caused by the etching process.

Here, the above-described silicon structure which has been subjected to the hole etching or the trench etching is formed by, for example, the heretofore known laser ablation method or reactive ion etching (RIE) method using a metal mask, etc.

Another method according to the present invention for manufacturing an etching mask for a silicon structure having an opening which has a high aspect ratio comprises the steps of: etching an organic deposit, by plasma generated by using oxygen or an oxygen-containing gas, on a silicon structure for which hole etching or trench etching has been performed by plasma generated by alternately rendering an etching gas and an organic deposit forming gas in a plasma state or generated by mixing the etching gas and the organic deposit forming gas; forming a silicon oxide film on the silicon structure by a CVD method after the step of etching the organic deposit; and exposing the silicon oxide film to a gas containing a hydrogen fluoride vapor after the step of forming the silicon oxide film.

According to this manufacturing method, first, the organic deposit on the etched portion of the inner wall of the silicon structure, more specifically, on the sidewall surface and the bottom surface and the resist film in a case of initially using the resist mask are removed; the silicon is exposed; and thereafter, an oxide film is formed by the CVD method. This forms a thick oxide film on the substrate topmost surface and the sidewall surface in the vicinity of the substrate topmost surface, as compared with the oxide film on the bottom surface and the sidewall in the vicinity of the bottom surface. Consequently, when thereafter, the silicon structure is exposed to the gas containing the hydrogen fluoride vapor, the silicon oxide film on the bottom surface and the sidewall surface in the vicinity of the bottom surface is removed earlier than the oxide film on the substrate topmost surface and the sidewall surface in the vicinity of the substrate topmost surface, whereby the oxide film on the substrate topmost surface and the sidewall surface in the vicinity of the substrate topmost surface remains. As a result, the remaining oxide film serves not only a function of protecting the sidewall surface in the vicinity of the topmost surface but also as a mask for the subsequent additional trench etching or hole etching. In other words, when the initial mask is the resist mask, the mask can be converted to a silicon oxide film mask having further strong etching resistance by applying the present invention. On the other hand, when the initial mask used upon the hole etching or the trench etching is a metal mask, a silicon oxide film, a silicon nitride film, or the like, a thickness of the oxide film is added thereto in the CVD, thereby allowing the mask to be reproduced after the depletion thereof caused by the etching process. According to the etching mask manufacturing method according to the present invention, even when the mask used upon the hole etching or the trench etching is the resist mask, the silicon structure having an opening which has a high aspect ratio can be eventually formed in a comparatively easy manner, though it is extremely difficult to achieve this by using the resist mask.

Furthermore, it deserves special mention that in the above-described process of forming the silicon oxide film by the CVD method, since the oxide film is formed in accordance with the existing etching shape, the oxide film is formed as the mask for the subsequent silicon etching without alignment. In other words, this achieves the so-called self-alignment technology.

A still another method according to the present invention for manufacturing an etching mask for a silicon structure having an opening which has a high aspect ratio comprises the steps of: etching an organic deposit, by plasma generated by using oxygen or an oxygen-containing gas, on a silicon structure for which hole etching or trench etching has been performed by plasma generated by alternately rendering an etching gas and an organic deposit forming gas in a plasma state or generated by mixing the etching gas and the organic deposit forming gas; forming a silicon oxide film on the silicon structure by a CVD method after the step of etching the organic deposit; exposing the silicon oxide film to a gas containing a hydrogen fluoride vapor after the step of forming the silicon oxide film; and repeating at least once more, after a step of performing the above-mentioned hole etching or the above-mentioned trench etching, the steps of etching the organic deposit, of forming the silicon oxide film, and of exposing the silicon oxide film to the gas containing the hydrogen fluoride vapor.

According to this manufacturing method, in addition to the same effects as the above-described effects of the present invention, attained is an effect that since the etching of the silicon is performed to some extent and thereafter, the silicon oxide filmmask, which is consumed by the above-mentioned etching, can be reproduced, an opening which has a high aspect ratio can be formed. Specifically, first, the silicon structure which has undergone the hole etching or the trench etching is subjected to the above-described steps of: etching the organic deposit by the above-described oxygen plasma or the like; forming the silicon oxide film by the CVD method; and the exposure to the gas containing the hydrogen fluoride vapor, and thereafter, the hole etching or the trench etching of the silicon is additionally performed. Thereafter, before the oxide film of the etching mask or the oxide film on the sidewall surface in the vicinity of the substrate topmost surface is removed upon the etching of the silicon, the etching process is once stopped and thereafter, the above-described steps of: etching the organic deposit; forming the oxide film; and the exposure to the gas containing the hydrogen fluoride vapor are conducted, thereby restoring a thickness of the etching mask and a thickness of the oxide film on the sidewall surface in the vicinity of the substrate topmost surface. Consequently, further additional hole etching or trench etching of the silicon can be continued, thereby enabling formation of the opening, which has a higher aspect ratio, in the silicon structure.

Each of the above-described silicon structure manufacturing methods according to the present invention has an advantage that though it is required to perform the etching to some extent before the oxide film is formed by the CVD method, the resist mask which has a lower etching resistance than that of the silicon oxide film or the silicon nitride film can be used in this initial etching. If it is necessary to use the mask of the silicon oxide film or the like in the initial etching, there arises a detriment that a patterning process for forming the mask is separately required.

In the present invention, the "high aspect ratio" in the hole etching refers to an aspect ratio of greater than or equal to 15 and in a narrower sense, to an aspect ratio of 20 or more. On the other hand, the "high aspect ratio" in the trench etching refers to an aspect ratio of greater than or equal to 30 and in a narrower sense, an aspect ratio of 40 or more. In addition, an upper limit of an aspect ratio attained by the present invention is not particularly limited. However, a value of the upper limit will be calculated substantially by using a relationship with a thickness of the silicon substrate which is a material to be etched.

In addition, as the "hole" in the present invention, not only an opening of a circular shape, as formed on the substrate topmost surface by mask patterning, but also an opening of an elliptical shape or a quadrangular shape are included. More specifically, the "hole" in the present invention refers to an opening, for example, in a case of the opening of the quadrangular shape whose relationship of a short side and a long side is 1 to 3 or less. In addition, the "trench" in the present invention refers to an opening other than the "hole".

In addition, as the case where the "silicon is substantially exposed" in the present invention, not only a case where the silicon is completely exposed but also a case where the silicon is covered by a native oxide film are included.

### EFFECT OF THE INVENTION

A silicon structure according to the present invention can have an opening which has a high aspect ratio, and by employing a manufacturing method, a manufacturing system, and a manufacturing program according to the present invention, the silicon structure having an opening which has a high aspect ratio can be manufactured by using a silicon material. In addition, by employing a method according to the present invention for manufacturing an etching mask, the etching mask which allows prevention of corrosion of an etched portion of a sidewall upon etching the silicon and also prevention of depletion of the etching mask under the etching can be manufactured. As a result, the invention of the method for manufacturing this etching mask enables manufacture or reproduction of the etching mask for forming an opening which has a high aspect ratio, in the silicon material.

### BRIEF DESCRIPTION OF THE DRAWINGS

[FIG. 1] FIG. 1 shows a top view of a system for manufacturing a silicon structure according to one embodiment of the present invention.
[FIG. 2] FIG. 2 shows a cross-section view illustrating one example of a configuration of a first process chamber according to the one embodiment of the present invention.
[FIG. 3] FIG. 3 shows a cross-section view illustrating one example of a configuration of a second process chamber according to the one embodiment of the present invention.
[FIG. 4] FIG. 4 shows a cross-section view illustrating one example of a configuration of a third process chamber according to the one embodiment of the present invention.
[FIG. 5A] FIG. 5A shows a cross-section view illustrating a step which a method according to the one embodiment of the present invention for manufacturing a silicon structure comprises.
[FIG. 5B] FIG. 5B shows a cross-section view illustrating a step which the method according to the one embodiment of the present invention for manufacturing the silicon structure comprises.
[FIG. 5C] FIG. 5C shows a cross-section view illustrating a step which the method according to the one embodiment of the present invention for manufacturing the silicon structure comprises.
[FIG. 5D] FIG. 5D shows a cross-section view illustrating a step which the method according to the one embodiment of the present invention for manufacturing the silicon structure comprises.
[FIG. 5E] FIG. 5E shows a cross-section view illustrating a step which the method according to the one embodiment of the present invention for manufacturing the silicon structure comprises.
[FIG. 5F] FIG. 5F shows a cross-section view illustrating a step which the method according to the one embodiment of the present invention for manufacturing the silicon structure comprises.
[FIG. 5G] FIG. 5G shows a cross-section view illustrating a step which the method according to the one embodiment of the present invention for manufacturing the silicon structure comprises.
[FIG. 5H] FIG. 5H shows a cross-section view illustrating a step which the method according to the one embodiment of the present invention for manufacturing the silicon structure comprises.
[FIG. 6] FIG. 6 is a flow chart for manufacturing the silicon structure according to the one embodiment of the present invention.
[FIG. 7] FIG. 7 shows a cross-section view illustrating one example of a configuration of a first process chamber according to another embodiment of the present invention.
[FIG. 8A] FIG. 8A shows a cross-section view illustrating a step which a method according to the another embodiment of the present invention for manufacturing a silicon structure comprises.
[FIG. 8B] FIG. 8B shows a cross-section view illustrating a step which the method according to the another embodiment of the present invention for manufacturing the silicon structure comprises.
[FIG. 8C] FIG. 8C shows a cross-section view illustrating a step which the method according to the another embodiment of the present invention for manufacturing the silicon structure comprises.
[FIG. 8D] FIG. 8D shows a cross-section view illustrating a step which the method according to the another embodiment of the present invention for manufacturing the silicon structure comprises.
[FIG. 8E] FIG. 8E shows a cross-section view illustrating a step which the method according to the another embodiment of the present invention for manufacturing the silicon structure comprises.
[FIG. 8F] FIG. 8F shows a cross-section view illustrating a step which the method according to the another embodiment of the present invention for manufacturing the silicon structure comprises.
[FIG. 9] FIG. 9 is a flow chart for manufacturing the silicon structure according to the another embodiment of the present invention.

### BEST MODE FOR CARRYING OUT THE INVENTION

Next, embodiments of the present invention will be described in detail with reference to the accompanying drawings. In the below descriptions, common reference numerals are used to denote common parts throughout all the drawings. In the drawings, the illustrated elements of the present embodiment are not necessarily to scale. Flow rates of the below-mentioned gases are those in standard conditions.

Here, in the following descriptions of the respective embodiments, not only a silicon structure having an opening which has a high aspect ratio, a manufacturing method thereof, a manufacturing system thereof, and a manufacturing program thereof but also substantially, a manufacturing method of an etching mask for the silicon structure having an opening which has a high aspect ratio, a manufacturing system thereof, a manufacturing program thereof are described. In other words, when viewed from a different perspective, the manufacturing system of the silicon structure in each of the below described embodiments can be substituted with the manufacturing system of the etching mask for the silicon structure. Accordingly, the description of the manufacturing method of the silicon structure in each of the below embodiments is that of the manufacturing method of the etching mask for the silicon structure. Similarly, the description of the manufacturing program of the silicon structure in each of the below embodiments is that of the manufacturing program of the etching mask for the silicon structure.

### <First Embodiment>

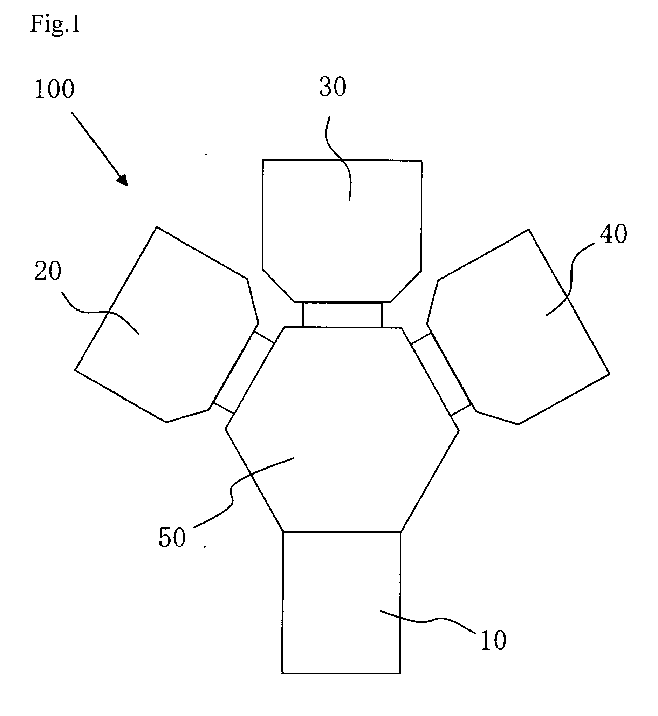

FIG. 1 shows a top view of a silicon structure manufacturing system of the present embodiment. Since FIG. 1 is a schematic diagram, peripheral units such as gas supply mechanisms and exhaust mechanisms of respective chambers are not shown. The silicon structure manufacturing system 100 comprises: three process chambers 20, 30, and 40 having closed spaces; one loader 10; and one transfer chamber 50. Here, the first process chamber 20 is used for performing anisotropic etching of silicon and for performing etching to remove an organic deposit. The organic deposit includes a resist mask and a sidewall deposited film which is formed by etching. In addition, the second process chamber 30 is used for forming a silicon oxide film on a surface of the mask and an inner wall of an etched portion by a CVD method. Lastly, the third process chamber 40 is used for removing or thinning a part of the above-mentioned oxide film by using a gas containing a vapor of hydrogen fluoride.

An outline of a process of manufacturing the silicon structure in the present embodiment will be described. First, a silicon substrate (hereinafter, also simply referred to as a substrate) including a resist mask previously patterned by conducting the heretofore known photolithography process is mounted on the heretofore known supporting member, not shown, which is provided in the loader 10. Thereafter, an arm mechanism in the transfer chamber 50, for example, like that which is disclosed in Japanese Patent Application Laid-Open Publication No. 10-154741 receives and transfers the substrate to the first process chamber 20. Thereafter, the silicon substrate is transferred via the transfer chamber 50 to each of the first, second, and third process chambers in accordance with each of the respective processes. Here, in the present embodiment, decompression by means of exhaustion is conducted in the loader 10. However, the decompression may be started after the substrate has moved to the transfer chamber 50 or the exhaustion may be started after the substrate has moved to each of the process chambers 20, 30, and 40. The exhaust mechanisms are provided so as to be associated with the loader 10, the transfer chamber 50, and the chambers 20, 30, and 40, respectively.

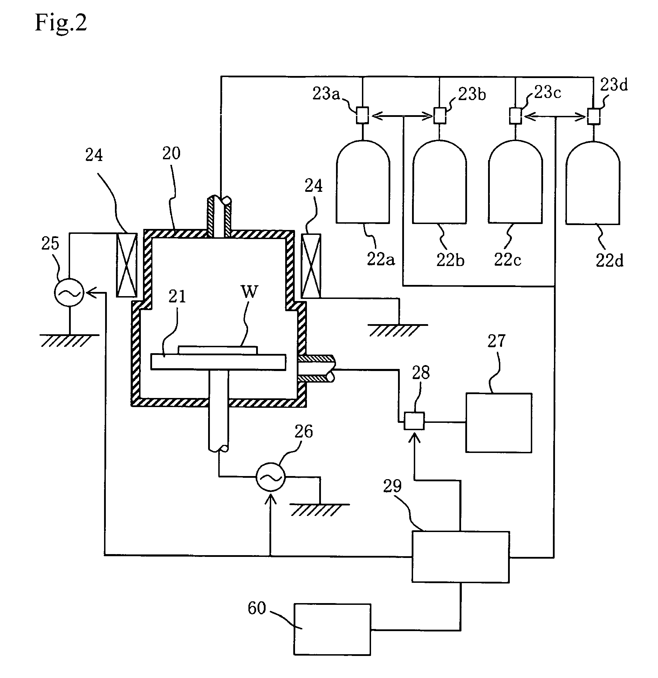

Next, a silicon structure manufacturing method in the present embodiment will be specifically described along a sequence of manufacturing processes with reference to FIG. 2 through FIG. 5H.

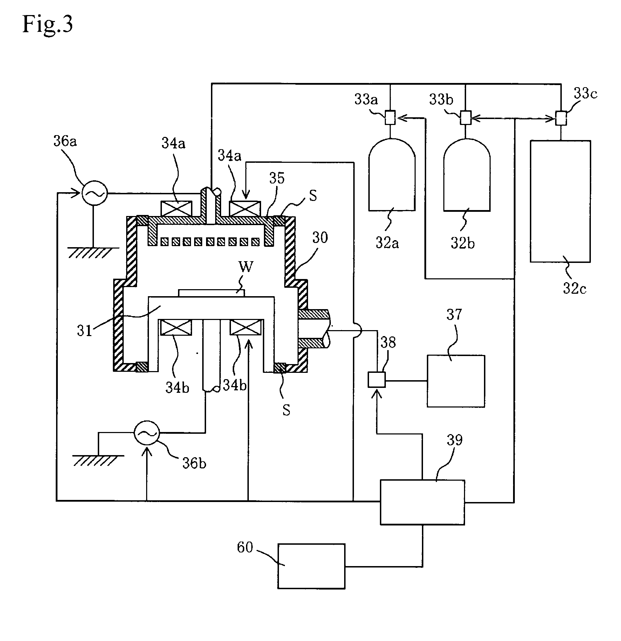

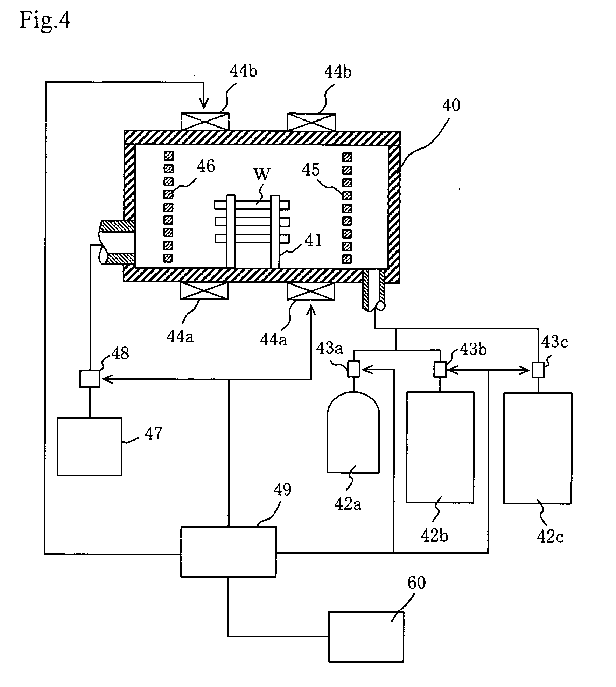

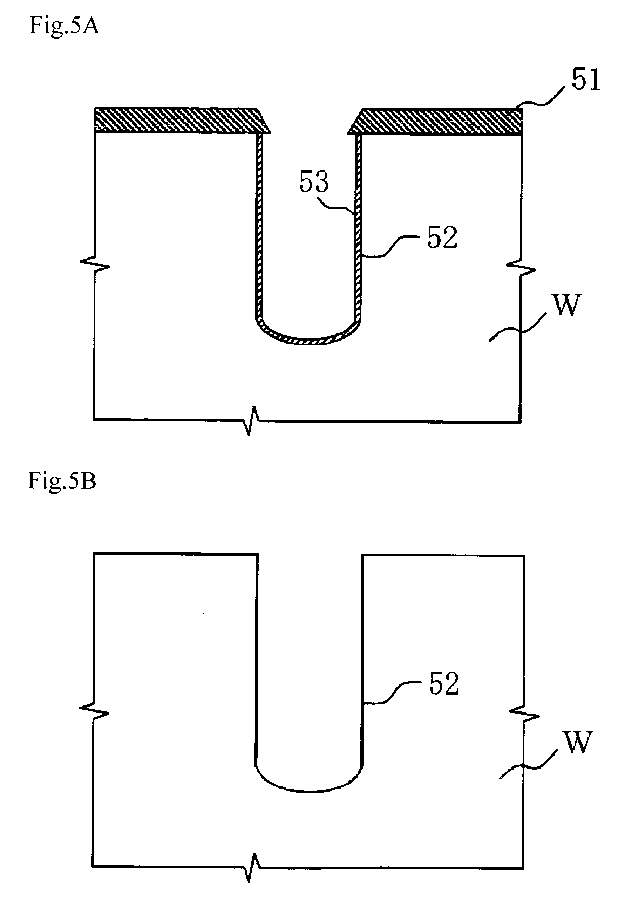

FIG. 2 shows a cross-section view illustrating one example of a configuration of the first process chamber 20. FIG. 3 shows a cross-section view illustrating one example of a configuration of the second process chamber 30. FIG. 4 shows a cross-section view illustrating one example of a configuration of the third process chamber 40. Further, FIG. 5A through FIG. 5H show cross-section views showing steps which the silicon structure manufacturing method of the present embodiment comprises.

First, the configuration of the first process chamber 20 shown in FIG. 2 will be described. The substrate W transferred to the first process chamber 20 (hereinafter, in the description of FIG. 2, also simply referred to as a chamber 20 for convenience sake) by the transfer chamber 50 is mounted on a stage 21 disposed in a lower portion of the chamber 20. At least one kind of a gas selected, as needed, from among an etching gas, an organic deposit forming gas (hereinafter, also referred to as a protection film forming gas), an oxygen gas, and an argon gas is supplied to the first process chamber 20 respectively from the cylinders 22a, 22b, 22c, and 22d respectively via the gas flow controller 23a, 23b, 23c, and 23d. These gases are rendered in a plasma state by a coil 24 to which a high-frequency power has been applied by a first high-frequency power source 25. Thereafter, a high-frequency power is applied to the stage 21 by a second high-frequency power source 26, whereby the generated plasma is drawn to the substrate W. In order to decompress an inside of the chamber 20 and exhaust a gas generated after the process, a vacuum pump 27 is connected to the first process chamber 20 via an exhaust flow controller 28. A rate of a flow exhausted from this chamber 20 is changed by the exhaust flow controller 28. The above-mentioned gas flow controller 23a, 23b, 23c, and 23d, first high-frequency power source 25, second high-frequency power source 26, and exhaust flow controller 28 are controlled by a controller 29.

Next, a process in the first process chamber 20 will be described. First, as a method of the anisotropic dry etching of the silicon in the present embodiment, a method in which a protection film forming process and an etching process are sequentially repeated is adopted. Specifically, in the protection film forming process, the protection film forming gas is supplied at 200 mL/min. for three seconds as one unit of processing time and a pressure in the chamber 20 is controlled at 3 Pa. Applied to the coil 24 is 2000 W of a high-frequency power of 13.56 MHz and also applied to the stage 21 is 10 W of a high-frequency power of 13.56 MHz. On the other hand, in the subsequent etching process, the etching gas is supplied at 300 mL/min. for five seconds as one unit of processing time and a pressure in the chamber 20 is controlled at 2 Pa. Applied to the coil 24 is 2500 W of a high-frequency power of 13.56 MHz and also applied to the stage 21 is 50 W of a high-frequency power of 13.56 MHz. Note that in the present embodiment, the protection film forming gas is C₄F₈ and the etching gas is SF₆.

By repeating the above-described processes 450 times, as shown in FIG. 5A, a trench having a depth of 151 µm is formed in a 5 µm-wide space formed in the substrate W. At this time, the remaining resist mask 51 is present on the substrate topmost surface and a sidewall protection film 53 is formed on an etched portion of the inner wall surface 52 (hereinafter, also simply referred to as an inner wall surface 52). Note that at this time point, an aspect ratio of the above-mentioned space is 30.2.

Next, a process of etching the remaining resist mask 51 and sidewall protection film 53 shown in FIG. 5A will be described. Note that the organic deposit in the present embodiment includes a resist material used as the mask and a polymer or an oligomer of fluorocarbon as the sidewall protection film.

In the present embodiment, the organic deposit is etched by using the first process chamber 20. Specifically, the oxygen gas is supplied at 100 mL/min. and a pressure in the chamber 20 is controlled at 5 Pa. Applied to the coil 24 is 1500 W of a high-frequency power of 13.56 MHz and also applied to the stage 21 is 50 W of a high-frequency power of 13.56 MHz. In the present embodiment, the process of etching the organic deposit under the above-mentioned plasma conditions is conducted for five minutes (with an overetching time included). Note that the argon gas may be added at 100 mL/min. to the above-mentioned oxygen gas. In addition, instead of the argon gas, nitrogen or dinitrogen monoxide can be applied.

Through conducting this etching process, as shown in FIG. 5B, the organic deposit covering the substrate topmost surface and the inner wall surface 52 of the substrate W is removed and as a result, the silicon is exposed.

Next, the configuration of the second process chamber 30 shown in FIG. 3 will be described. The substrate W transferred to the second process chamber 30 (hereinafter, in the description of FIG. 3, also simply referred to as a chamber 30 for convenience sake) by the transfer chamber 50 is mounted on a stage 31 disposed in the vicinity of a central portion of the chamber 30. The substrate W and an inside of the chamber 30 are heated by heaters 34a and 34b provided on an outer wall of the chamber 30. A gas cylinder 32a of the oxygen gas is connected via a gas flow controller 33a to and a gas cylinder 32b of the argon gas is connected via a gas flow controller 33b to the second process chamber 30. Further, a tetra ethyl ortho silicate (hereinafter, referred to as TEOS) cabinet 32c is connected via a liquid flow controller 33c to the second process chamber 30. Here, a pipe extending from the TEOS cabinet 32b to the chamber 30 is heated to approximately 100°C by a heater not shown. In the present embodiment, although the TEOS is used, silane or disilane may be used, instead of the TEOS. In addition, though not shown, a cylinder of a carrier gas (hydrogen, nitrogen, etc.) other than the above-mentioned gases may be connected to the chamber 30. The gases fed from the gas cylinder 32a of the oxygen gas, the gas cylinder 32b of the argon gas, and the TEOS cabinet 32c eventually pass through the same channel and reach the chamber 30. The first high-frequency power source 36a applies a high-frequency power to a shower head gas introducing unit 35, whereby the above-mentioned gases discharged from the shower head introducing unit 35 are rendered in a plasma state. The generated plasma reaches the substrate W on the stage 31 to which the high-frequency power has been applied, as needed, by the second high-frequency power source 36b. The shower head gas introducing unit 35 is electrically insulated from the chamber 30 by a ring-shaped sealing material S. The stage 31 is also electrically insulated from the chamber 30 by a ring-shaped sealing material S. In addition, in order to decompress an inside of the chamber 30 and exhaust a gas generated after the process, a vacuum pump 37 is connected via an exhaust flow controller 38 to the second process chamber 30. Furthermore, a rate of a flow exhausted from this chamber 30 is changed by the exhaust flow controller 38. The above-mentioned gas flow controllers 33a and 33b, liquid flow controller 33c, heaters 34a and 34b, first high-frequency power source 36a, second high-frequency power source 36b, and exhaust flow controller 38 are controlled by a controller 39.

Next, a process in the second process chamber 30 will be described. In the present embodiment, by using the second process chamber 30, a silicon oxide film is formed on the substrate W including the inner wall surface 52 from which the organic deposit has been removed. Specifically, until a pressure in the chamber 30 reaches 40 Pa, the TEOS at 15 mL/min., the argon gas at 300 mL/min., the oxygen gas at 500 mL/min., and the carrier gas at an appropriate flow rate as needed are supplied to the chamber 30. Next, until a temperature of the stage 31 reaches 300°C, heaters 34a and 34b are heated. Here, in order to stabilize a temperature of the substrate W, a standby time of greater than or equal to 60 seconds is provided. Thereafter, 200 W of a high-frequency power is applied to the shower head gas introducing unit 35 and 200 W of a high-frequency power is applied to the stage 31. In the present embodiment, the process of forming the oxide film under the above-mentioned plasma conditions is conducted for six minutes.

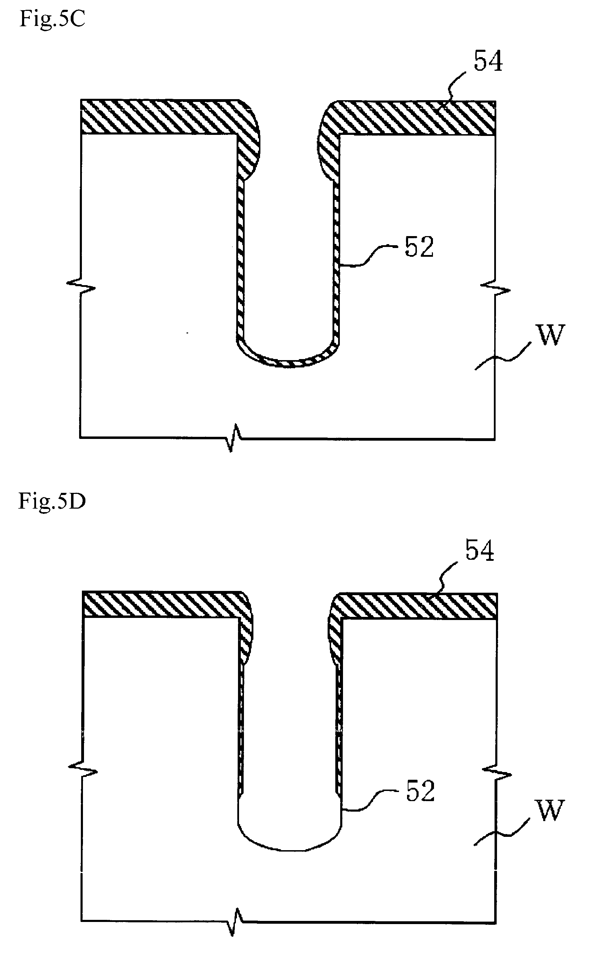

By conducting the above-described process, as shown in FIG. 5C, in the 5 µm-wide space formed in the substrate W, a thickness of the silicon oxide film on the substrate topmost surface comes to be 1.5 µm and a thickness of the silicon oxide film on the sidewall surface in the vicinity of the substrate topmost surface comes to be 0. 3 µm. On the other hand, a thickness of the silicon oxide film on the bottom surface comes to be 0.05 µm and a thickness of the silicon oxide film on the sidewall surface in the vicinity of the bottom surface comes to be 0.02 µm.

Next, the configuration of the third process chamber 40 shown in FIG. 4 will be described. The substrate W transferred to the third process chamber 40 (hereinafter, in the description of FIG. 4, also simply referred to as a chamber 40 for convenience sake) by the transfer chamber 50 is held by a substrate holder 41 disposed in the vicinity of a central portion of the chamber 40. The substrate W and an inside of the chamber 40 are heated by heaters 44a and 44b provided on an outer wall of the chamber 40. A gas cylinder 42a of a nitrogen gas as a carrier gas is connected via a gas flow controller 43a to and a methanol cabinet 42b is connected via a liquid flow controller 43b to the third process chamber 40. In addition, a hydrogen fluoride cabinet 42c is connected via a liquid flow controller 43c to the third process chamber 40. Here, at least a pipe extending from the methanol cabinet 42b and the hydrogen fluoride cabinet 42c to the chamber 40 is heated to approximately 70°C by a heater not shown, thereby preventing liquefaction. In addition, a cylinder of a carrier gas (argon, etc.) other than the above-mentioned nitrogen may be connected to the chamber 40. A methanol vapor to which the nitrogen gas is supplied as the carrier gas passes through the same channel, through which a hydrogen fluoride vapor passes, and eventually reaches the chamber 40. Since the above-mentioned respective gases introduced into the chamber 40 are fed from a diffuser plate 45 for gas introduction toward the substrate W, the substrate W is exposed to the above-mentioned respective gases. In order to decompress an inside of the chamber 40 and exhaust a gas generated after the process, a vacuum pump 47 is connected to the third process chamber 40 via an exhaust flow controller 48. In addition, a rate of a flow exhausted from this chamber 40 is changed by the exhaust flow controller 48. The above-mentioned respective gases which have contacted the substrate W are exhausted together with the generated gas via a diffuser plate 46 for exhaust. The above-mentioned gas flow controller 43a, liquid flow controllers 43b and 43c, heaters 44a and 44b, and exhaust flow controller 48 are controlled by a controller 49.

Next, a process in the third process chamber 40 will be described. In the present embodiment, by using the third process chamber 40, a part of the silicon oxide film formed by using the second process chamber is removed or thinned. Specifically, first, heaters 44a and 44b are heated until temperatures thereof reach 60°C. Here, in order to stabilize a temperature of the substrate W, a standby time of greater than or equal to 60 seconds is provided. Next, a mixture gas of the methanol vapor and the nitrogen gas is supplied at 1500 mL/min. , the hydrogen fluoride vapor is supplied at 150 mL/min., and a pressure in the chamber 40 is adjusted at 4 Pa. In the present embodiment, the process of removing or thinning the oxide film under the above-described exposure conditions is conducted for two minutes.

By conducting the above-described process, as shown in FIG. 5D, in the 5 µm-wide space formed in the substrate W, a thickness of the silicon oxide film on the substrate topmost surface comes to be 1.1 µm and a thickness of the silicon oxide film on the sidewall surface in the vicinity of the substrate topmost surface comes to be 0.1 µm. On the other hand, the silicon oxide film on the bottom surface is removed to an extent to which the silicon oxide film thereon cannot be confirmed by a SEM (scanning electron microscope) and the silicon oxide film on the sidewall surface in the vicinity of the bottom surface is also substantially removed.

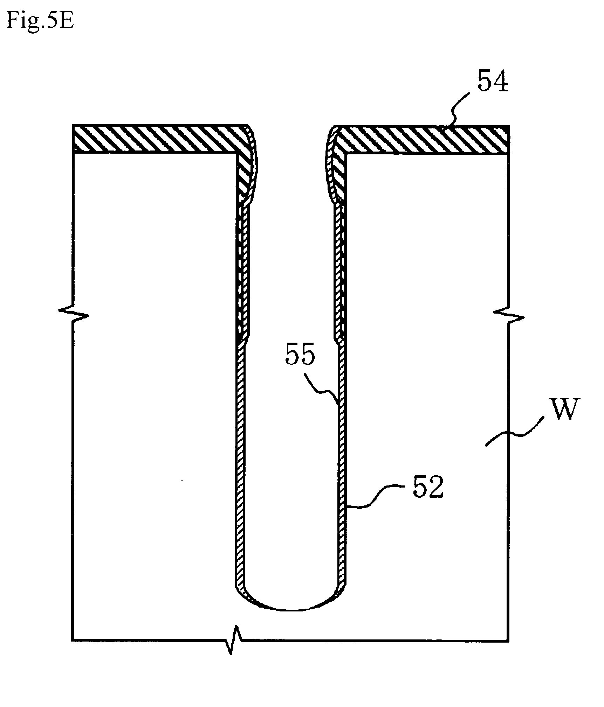

In the present embodiment, as shown in FIG. 5E, by using the first process chamber 20, the anisotropic dry etching of the silicon is further performed. The substrate W is sent from the third process chamber via the transfer chamber 50 to the first process chamber. The process conditions in the first process chamber 20 at this time are the same as the above-mentioned conditions under which the anisotropic dry etching of the silicon is initially performed, except for the processing time. In the process conducted this time, since the protection film forming process and the etching process are repeated 450 times, an overall etching depth in the 5 µm-wide space formed in the substrate W comes to be 276 µm. As a result, an aspect ratio in this space comes to be 54.7.

Next, an etching process to remove the organic deposit by using the first process chamber is performed. The process conditions at this time are the same as the above-mentioned conditions under which the process of etching the organic deposit is initially conducted, except for the processing time. In the process conducted this time, the process of etching the organic deposit under the above-mentioned plasma conditions is conducted for three minutes (with an overetching time included).

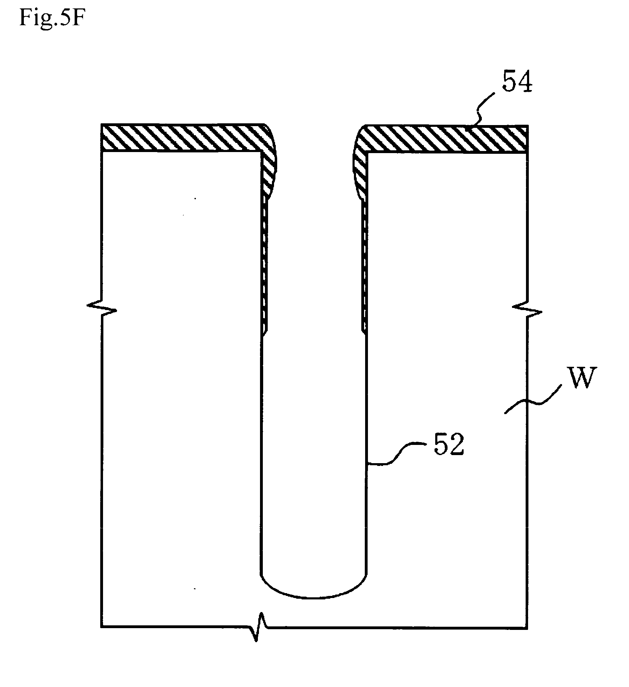

By conducting this etching process, as shown in FIG. 5F, the organic deposit covering the substrate topmost surface and the inner wall surface 52 of the substrate W is removed and as a result, a part of the silicon, which has been newly anisotropically-etched, is exposed.

Next, by using the second process chamber 30 again, a silicon oxide film is formed on the substrate W including the inner wall surface 52 from which the organic deposit has been removed. The substrate W is sent from the first process chamber via the transfer chamber 50 to the second process chamber. The process conditions under which the second process chamber 30 is used at this time are the same as the above-mentioned conditions under which the process of forming the silicon oxide film by the CVD method is initially conducted, except for the processing time. In the process conducted this time, the process of forming the oxide film under the above-described CVD conditions is conducted for three minutes.

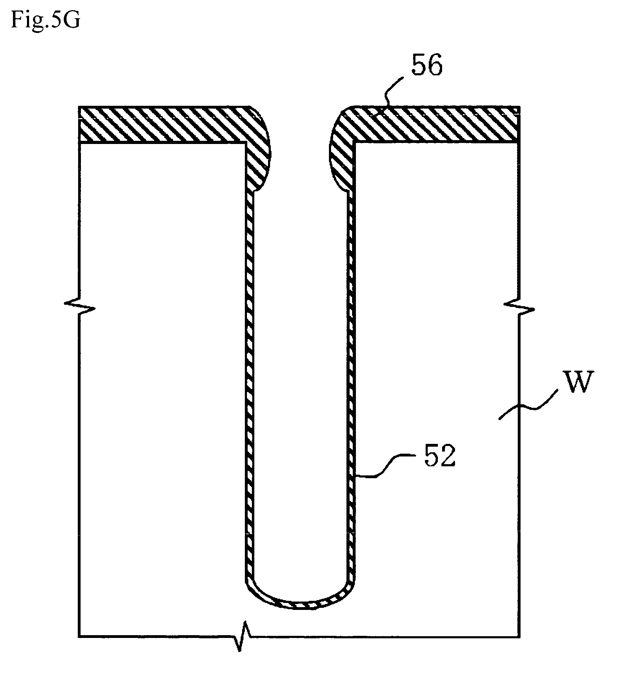

By conducting the above-described process, as shown in FIG. 5G, in the 5 µm-wide space formed in the substrate W, a thickness of the silicon oxide film on the substrate topmost surface comes to be 1.5 µm and a thickness of the silicon oxide film on the sidewall surface in the vicinity of the substrate topmost surface comes to be 0.3 µm. In other words, a thickness of the silicon oxide film 56 on the substrate topmost surface, which can serve as a mask when the additional anisotropic dry etching of the silicon is subsequently performed, is restored by the above-described process. On the other hand, a thickness of the silicon oxide film on the bottom surface comes to be 0.03 µm and a thickness of the silicon oxide film on the sidewall surface in the vicinity of the bottom surface comes to be 0.01 µm.

Thereafter, by using the third process chamber 40 again, a part of the silicon oxide film formed by using the second process chamber is removed or thinned. The substrate W is sent from the second process chamber via the transfer chamber 50 to the third process chamber. The process conditions under which the third process chamber 40 is used at this time are the same as the above-mentioned conditions under which the process of exposing the substrate W to the gas containing the hydrogen fluoride vapor is initially conducted, except for the processing time. In the process conducted this time, the exposure process under the above-mentioned conditions is conducted for two minutes.

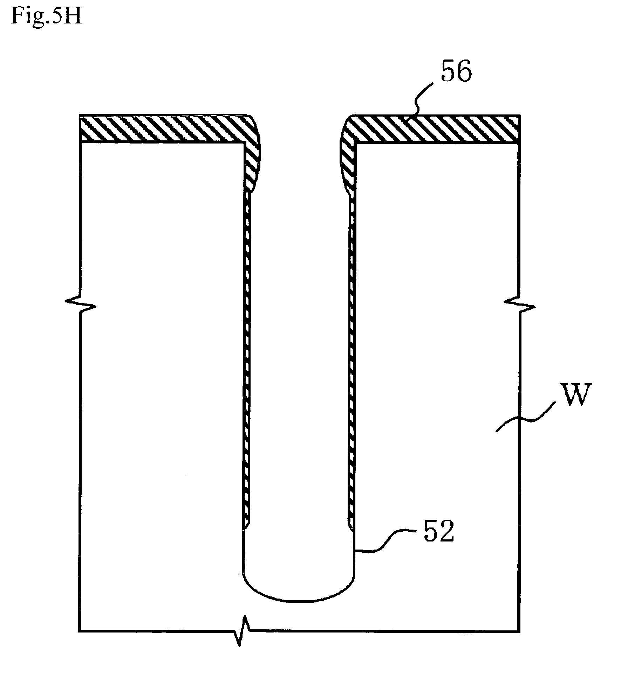

By conducting the above-described process, as shown in FIG. 5H, in the 5 µm-wide space formed in the substrate W, a thickness of the silicon oxide film on the substrate topmost surface comes to be 1.1 µm and a thickness of the silicon oxide film on the sidewall surface in the vicinity of the substrate topmost surface comes to be 0.1 µm. On the other hand, the silicon oxide film on the bottom surface is removed to an extent to which the silicon oxide film thereon cannot be confirmed by a SEM and the silicon oxide film on the sidewall surface in the vicinity of the bottom surface is also substantially removed.

As described above, through repeatedly conducting the respective processes by using the first, second, and third process chambers, when the anisotropic dry etching of the silicon is performed, prevention of the corrosion of the etched portion of the sidewall and prevention of the depletion of the mask are concurrently achieved, thereby enabling the formation of the silicon structure having an opening which has a high aspect ratio.

### <Second Embodiment>

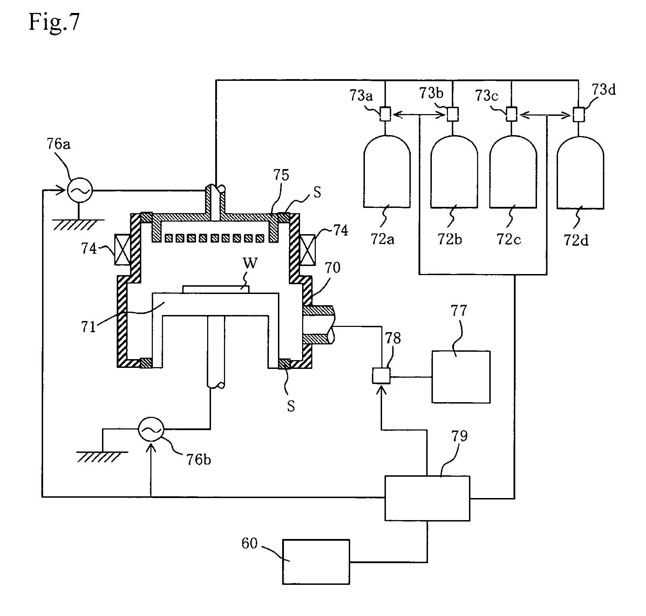

A silicon structure manufacturing system according to the present embodiment has the same system configuration as that shown in FIG. 1 except that the first process chamber 20 shown in FIG. 1 is replaced with an RIE apparatus 70 shown in FIG. 7. Only in the description of the present embodiment, the RIE apparatus 70 is referred to as a first process chamber for convenience sake. Also in the description of the present embodiment, common reference numerals are used to denote common parts throughout all the associated drawings. In the drawings, the illustrated elements of the present embodiment are not necessarily to scale. Flow rates of the below-mentioned gases are those in standard conditions.

Next, processes in the present embodiment will be described mainly with reference to FIG. 7, FIG. 8A through FIG. 8F, and FIG. 9. Accordingly, the descriptions regarding the system configuration shown in FIG. 3 and FIG. 4, to which the description of the present embodiment is also given with reference, and regarding the process conditions in the system are omitted since the system configuration and process conditions in the present embodiment are the same as those in the first embodiment.

First, a configuration of the first process chamber 70 shown in FIG. 7 will be described. A substrate W transferred to the first process chamber 70(hereinafter, in the description of FIG. 7, also simply referred to as a chamber 70 for convenience sake) by a transfer chamber 50 is mounted on a stage 71 disposed in the vicinity of a central portion of the chamber 70. An etching gas (SF₆ in the present embodiment), an oxygen gas, a chlorine gas, and a hydrogen bromide gas are supplied to the first process chamber 70 respectively from cylinders 72a, 72b, 72c, and 72d respectively via gas flow controllers 73a, 73b, 73c, and 73d. Among the above-mentioned gases, the chlorine gas and the hydrogen bromide gas are not indispensable in this process and are supplied when needed. At least the gases fed from the gas cylinder 72a of SF₆ and the gas cylinder 72b of the oxygen gas eventually pass through the same channel and reach the chamber 70. A first high-frequency power source 76a applies a high-frequency power to a shower head gas introducing unit 75, whereby the above-mentioned gases discharged from the shower head introducing unit 75 are rendered in a plasma state. Here, a density of the plasma generated in the chamber 70 is enhanced by a permanent magnet 74 provided on an outer wall of the chamber 70. The generated plasma reaches the substrate W on the stage 71 to which a high-frequency power has been applied by a second high-frequency power source 76b as needed. The shower head gas introducing unit 75 is electrically insulated from the chamber 70 by a ring-shaped sealing material S. The stage 71 is also electrically insulated from the chamber 70 by a ring-shaped sealing material S. In addition, in order to decompress an inside of the chamber 70 and exhaust a gas generated after the process, a vacuum pump 77 is connected via an exhaust flow controller 78 to the first process chamber 70. Furthermore, a rate of a flow exhausted from this chamber 70 is changed by the exhaust flow controller 78. The above-mentioned gas flow controllers 73a, 73b, 73c, and 73d, first high-frequency power source 76a, second high-frequency power source 76b, and exhaust flow controller 78 are controlled by a controller 79.

Next, a process in the first process chamber 70 will be described. First, as a method of the anisotropic dry etching of the silicon in the present embodiment, an RIE method utilizing the heretofore known silicon oxide film mask as an etching mask is adopted. Specifically, SF₆ at 200mL/min. is supplied to and oxygen at 40mL/min. is supplied to the chamber 70 and a pressure in the chamber 70 is adjusted at 30 Pa. Applied to the stage holding the silicon substrate W is 2000 W of a high-frequency power.

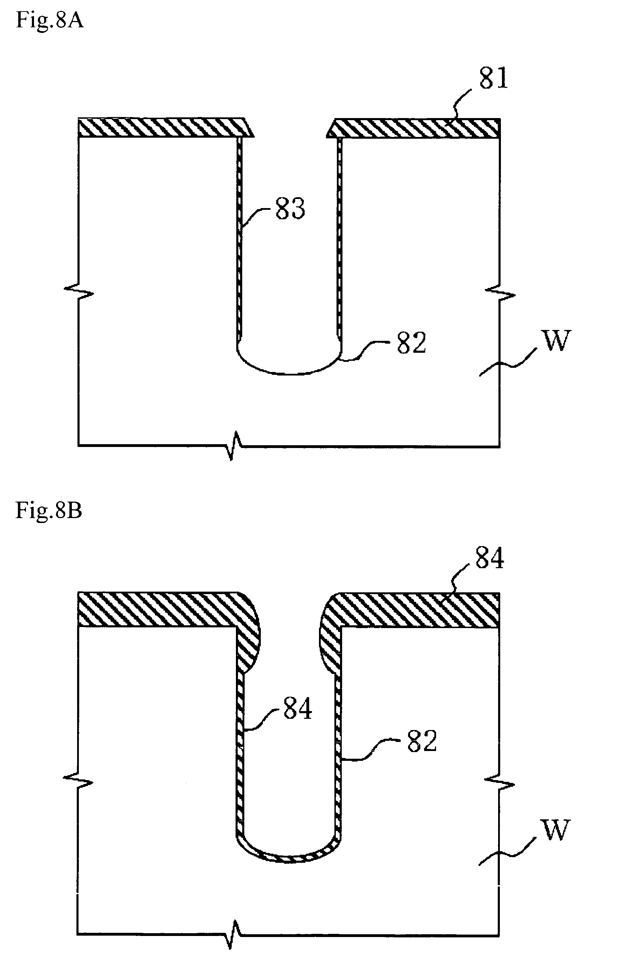

Under the above-described exemplary conditions, the silicon is etched so as to have a hole shape or a trench shape as shown in FIG. 8A. Here, a sidewall protection film 83 which is considered to be a silicon oxide film is formed on a surface of the etched portion of an inner wall 82.

Thereafter, the substrate W is transferred to a second process chamber 30 by the transfer chamber 50 and as shown in FIG. 8B, a silicon oxide film 84 is formed in the second process chamber 30 by a CVD method. An initial silicon oxide film mask 81 is substantially integrated with the silicon oxide film 84 by conducting this process.

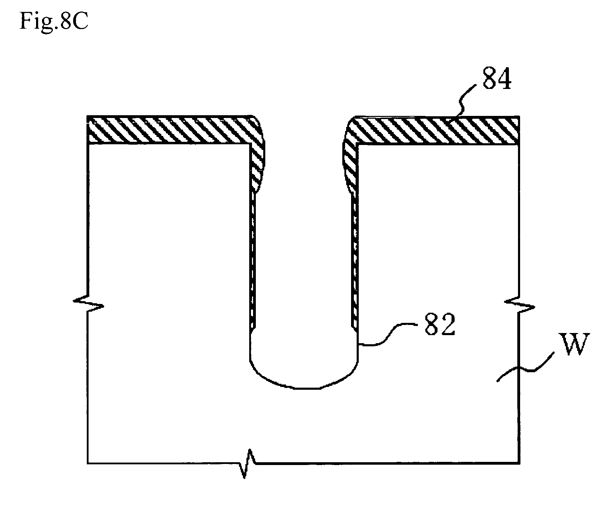

After the silicon oxide film has been formed, the substrate W is transferred by the transfer chamber 50 to a third process chamber 40 and exposed to a gas containing a hydrogen fluoride vapor in the third process chamber 40, whereby the silicon oxide film on the etched portion of a bottom surface and in the vicinity thereof is removed as shown in FIG. 8C.

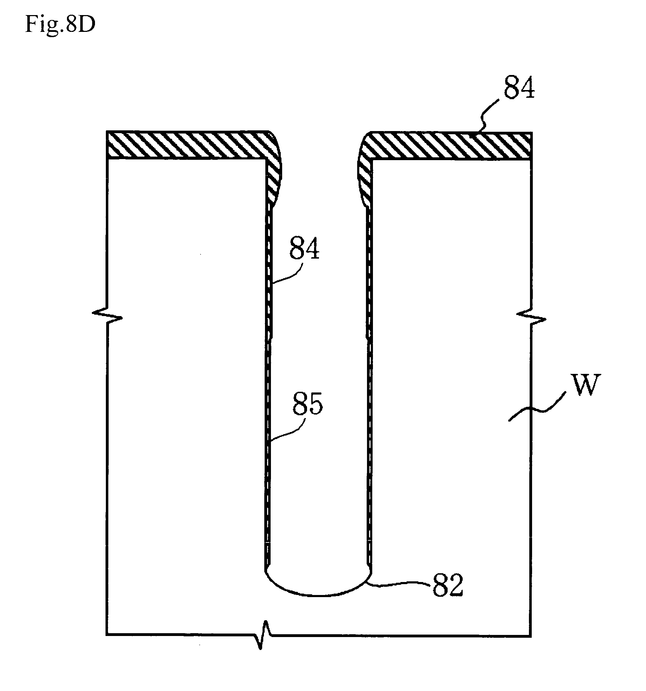

By conducting the above-described exposure process, the portion of the bottom surface of the etched silicon is exposed. In a case where it is desired that a hole shape or a trench shape having a higher aspect ratio is obtained, the substrate W is transferred again to the first process chamber and the anisotropic dry etching of the above-mentioned silicon is performed as shown in FIG. 8D. As a result, in addition to the silicon oxide film 84, a sidewall protection film 85 is formed on a surface of the etched portion of the inner wall 82 in a manner similar to the above-described manner.

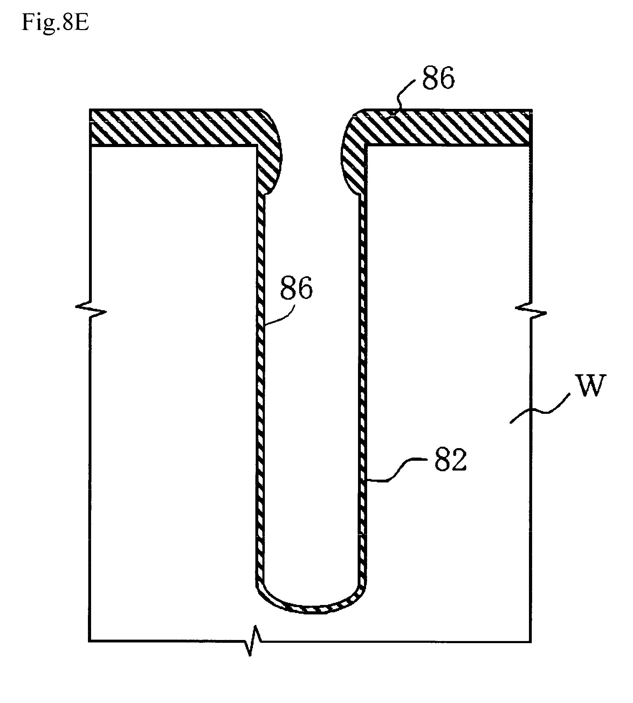

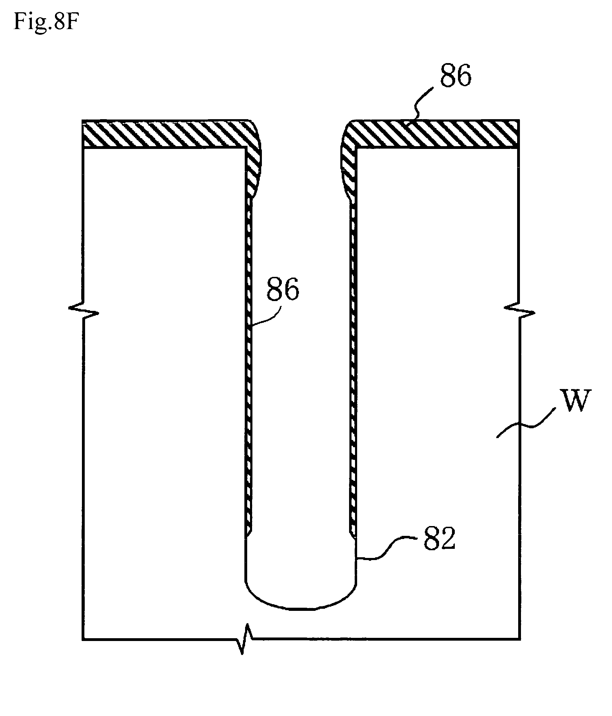

Thereafter, in a case where it is desired that an aspect ratio is further enhanced, the processes using the second process chamber 30 and the third process chamber 40 are further conducted as shown in FIG. 8E and FIG. 8F. As a result, the third anisotropic dry etching of the silicon can be performed without depleting the etching mask.

In each of the above-described embodiments, the respective controllers 29, 39, 49, and 79 provided for the respective process chambers are all connected to a computer 60. The computer 60 monitors or totally controls the above-described respective processes by a silicon structure manufacturing program for conducting the above-described respective processes. Hereinafter, the silicon structure manufacturing program will be described with reference to a specific manufacturing flow chart. In the present embodiment, the above-mentioned manufacturing program is stored in the heretofore known storage medium such as a hard disk drive in the computer 60, an optical disk which is inserted into an optical disk drive provided in the computer 60, or the like. However, what has this manufacturing program stored therein is not limited thereto. For example, a part or all of this manufacturing program may be stored in each of the respective controllers 29, 39, 49, and 79 provided in the respective process chambers. In addition, this manufacturing program can monitor or control the above-described respective processes by employing the heretofore known technology such as a local area network and an Internet connection.

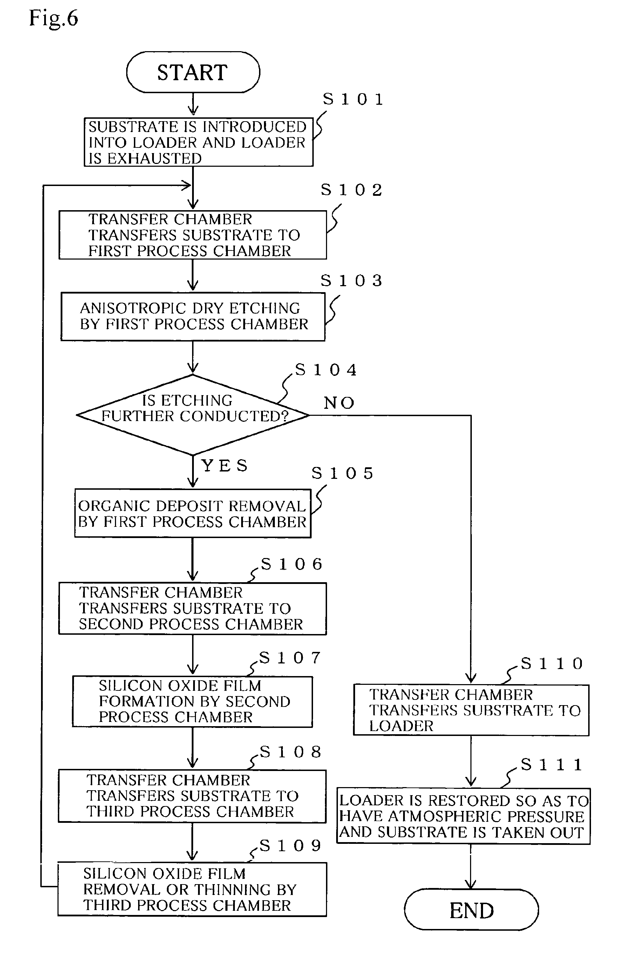

First, a silicon structure manufacturing program in the first embodiment will be described. FIG. 6 is a flow chart for manufacturing the silicon structure having an opening which has a high aspect ratio in the first embodiment.

As shown in FIG. 6, first at step S101, the substrate W is introduced into the loader 10 and thereafter, the loader 10 is exhausted. Thereafter, at step S102, the substrate W is transferred by the transfer chamber 50 to the first process chamber 20. At step S103, in the first process chamber 20, the substrate W is subjected to the anisotropic dry etching under the previously-described conditions. Here, in a case where an opening which has a higher aspect ratio is formed, the process proceeds to the next step S105. Otherwise, at step S110, the substrate W is transferred to the loader 10 by the transfer chamber 50. At subsequent step S111, the loader 10 is restored so as to have an atmospheric pressure and the substrate is taken out, whereby the process is finished.

At step S105, in the first process chamber 20, the organic deposit on the substrate W is etched and removed under the previously-described conditions. Thereafter, at step S106, the substrate W is transferred to the second process chamber 30 by the transfer chamber. At step S107, in the second process chamber 30, a silicon oxide film is formed on the substrate W under the previously-described process conditions based on the CVD method. The oxide film formed at this time serves not only a function of protecting the sidewall but also as the etching mask for the subsequent anisotropic etching of the silicon through so-called self-alignment technology. Further at step S108, the substrate W is transferred to the third process chamber 40 by the transfer chamber 50. At step S109, in the third process chamber 40, the silicon oxide film on the substrate W is removed or thinned under the previously-described exposure conditions. Thereafter, at step S102, the substrate W is transferred again to the first process chamber 20 and in order to form an opening which has a higher aspect ratio, subjected to the anisotropic dry etching under the previously-described conditions. By repeating steps S102 through S109, the silicon structure having an opening which has a higher aspect ratio is manufactured. As described above, the silicon structure manufacturing program is executed.

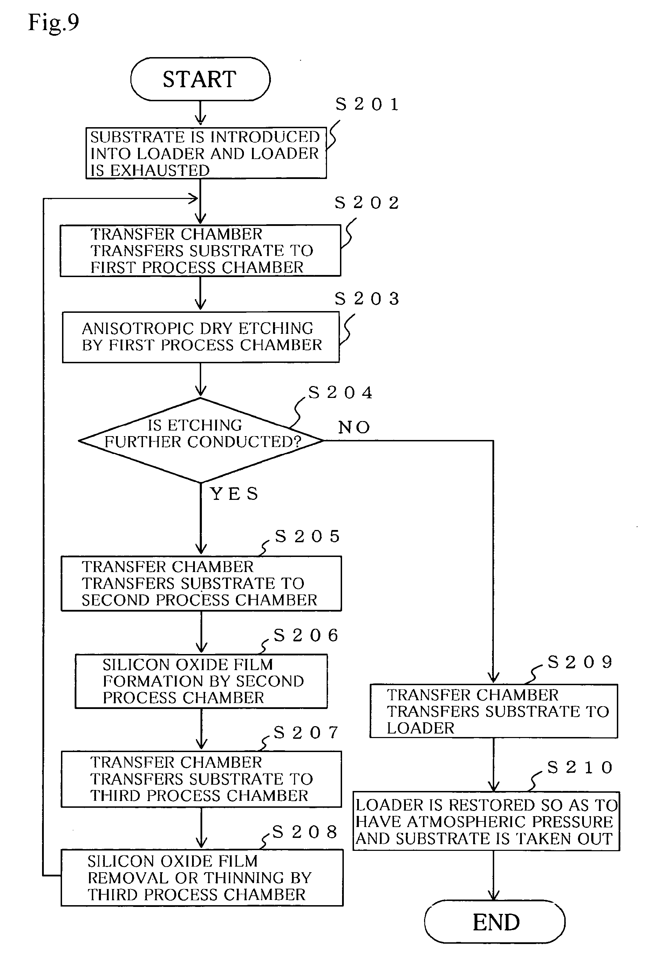

Next, a silicon structure manufacturing program in the second embodiment will be described. FIG. 9 is a flow chart for manufacturing the silicon structure having an opening which has a high aspect ratio in the second embodiment. Also here, only in the description of the present embodiment, this RIE apparatus 70 is referred to as a first process chamber for convenience sake.

As shown in FIG. 9, first at step S201, the substrate W is introduced into the loader 10 and thereafter, the loader 10 is exhausted. Thereafter, at step S202, the substrate W is transferred by the transfer chamber 50 to the first process chamber 70. At step S203, in the first process chamber 70, the substrate W is subjected to the anisotropic dry etching under the previously-described conditions. Here, in a case where an opening which has a higher aspect ratio is formed, the process proceeds to the next step S205. Otherwise, at step S209, the substrate W is transferred to the loader 10 by the transfer chamber 50. At subsequent step S210, the loader 10 is restored so as to have an atmospheric pressure and the substrate is taken out, whereby the process is finished.

At step S205, the substrate W is transferred to the second process chamber 30 by the transfer chamber. At step S206, in the second process chamber 30, a silicon oxide film is formed on the substrate W under the previously-described process conditions based on the CVD method. The oxide film formed at this time serves not only a function of protecting a sidewall but also as an etching mask for the subsequent anisotropic etching of the silicon through so-called self-alignment technology. Further at step S207, the substrate W is transferred to the third process chamber 40 by the transfer chamber 50. At step S208, in the third process chamber 40, the silicon oxide film on the substrate W is removed or thinned under the previously-described exposure conditions. Thereafter, at step S202, the substrate W is transferred again to the first process chamber 70 and in order to form an opening which has a higher aspect ratio, subjected to the anisotropic dry etching under the previously-described conditions. By repeating steps S202 through S208, the silicon structure having an opening which has a higher aspect ratio is manufactured. As described above, the silicon structure manufacturing program is executed.

Each of the above-described embodiments is applicable to not only a trench etching but also a hole etching. For example, by applying the present invention, even when a resist mask is used as an initial mask, the anisotropic etching of the silicon can be realized without depleting the etching mask so as to achieve an aspect ratio of 25 in the vicinity of an entrance of a hole-shaped opening having a diameter of 10 µm.

In addition, in the present invention, a width of the hole or trench formed by the etching is not particularly limited. However, if the width were to be determined, the following would be considered.

First, it is preferable that the shortest width of an entrance of a hole which is formed by applying the present invention is less than or equal to 30 µm. This is because if the above-mentioned width exceeds 30 µm, a thickness of the oxide film on the bottom surface of the opening is increased upon forming the silicon oxide film and when the subsequent process of removing or thinning the oxide film is conducted, it is made comparatively difficult to remove, while the oxide film on the sidewall surface in the vicinity of the entrance remains, the oxide film on the bottom surface of the opening. From such a point of view, it is more preferable that the above-mentioned width is less than or equal to 20 µm and it is most preferable that the above-mentioned width is less than or equal to 15 µm. A lower limit of the shortest width of the entrance of the hole which is formed by applying the present invention is not particularly determined. However, in a case of the hole etching, it can be said that there is a high risk that the entrance is blocked due to the CVD method and it is made difficult to appropriately form the entrance even in the subsequent process of exposing the substrate to the gas containing the hydrogen fluoride vapor. Therefore, it can be said that it is preferable that the above-mentioned lower limit is greater than or equal to 0.3 µm and it is more preferable that the above-mentioned lower limit is greater than or equal to 0.7 µm.

On the other hand, it is preferable that the shortest width of an entrance of a trench is less than or equal to 15 µm. This is because if the above-mentioned width exceeds 15 µm, a thickness of the oxide film on the bottom surface of the opening is increased upon forming the silicon oxide film and when the subsequent process of removing or thinning the oxide film is conducted, it is made comparatively difficult to remove, while the oxide film on the sidewall surface in the vicinity of the entrance remains, the oxide film on the bottom surface of the opening. From such a point of view, it is more preferable that the above-mentioned width is less than or equal to 10 µm and it is most preferable that the above-mentioned width is less than or equal to 5 µm. A lower limit of the shortest width of the entrance of the trench which is formed by applying the present invention is not particularly determined. However, in a case of the trench etching, it can be said that there is a high risk that the entrance is blocked due to the CVD method and it is made difficult to appropriately form the entrance even in the subsequent process of exposing the substrate to the gas containing the hydrogen fluoride vapor. Therefore, it is preferable that the above-mentioned lower limit is greater than or equal to 0.5 µm and it is more preferable that the above-mentioned lower limit is greater than or equal to 1 µm.

In each of the above-described embodiments, the substrate which has not been etched is initially used. However, in a silicon structure which has already undergone the hole etching or the trench etching, an opening which has a high aspect ratio can be formed by applying the present invention. The present invention enables the etched portion of the sidewall to be protected as well as the depletion of the mask to be prevented. Accordingly, for example, in a case where an opening which has a high aspect ratio is formed in the trench etching, applying the present invention to further enhance an aspect ratio for a silicon structure having an opening which has an aspect ratio of greater than or equal to 30 is one preferred embodiment. In addition, in the trench etching, it is particularly preferable to apply the present invention in a case where an aspect ratio is greater than or equal to 40. On the other hand, in a case where an opening which has a high aspect ratio is formed in the hole etching, applying the present invention to further enhance an aspect ratio for a silicon structure having an opening which has an aspect ratio of greater than or equal to 15 is one preferred embodiment. In addition, in the hole etching, it is particularly preferable to apply the present invention in a case where an aspect ratio is greater than or equal to 20.

In addition, a method of forming the silicon structure, as a starting material, which has already undergone the hole etching or the trench etching is not limited. As previously described, the present invention can be applied even to a silicon structure, as a starting material, in which a hole or a trench has been formed by a heretofore known laser ablation method or the like. Hereinafter, a case where each of the above-described embodiments is applied to the silicon structure which has already undergone the etching will be described with reference to FIG. 6 and FIG. 9.

First, the above-mentioned silicon structure is introduced into the loader and thereafter, the loader is exhausted (S101, S201). Next, in a case where an etched portion of the silicon on an inner wall surface of the silicon structure is exposed, the silicon structure is transferred to the second process chamber 30 by the transfer chamber 50 (S205) and an oxide film is formed by using the second process chamber (S206). The subsequent processes are conducted in accordance with the flow chart shown in FIG. 9. In other words, in this case, steps S202 through S204 at the initial stage are skipped.

On the other hand, if an organic deposit (for example, residues of a resist film) is present on the silicon structure, the silicon structure is transferred to the first process chamber 20 by the transfer chamber 50 (S102) and subsequently, a process of removing the organic deposit in the first process chamber 20 by etching is conducted (S105). The subsequent processes are conducted in accordance with the flow chart shown in FIG. 6. In other words, in this case, steps S103 and S104 at the initial stage are skipped. In either of the above-mentioned cases, the conditions disclosed in the above-described embodiments are applicable as the respective process conditions.

In each of the above-described embodiments, the resist mask is used as the initial etching mask. However, as already described, a silicon oxide film or a silicon nitride film may be used. In a case where a silicon oxide film mask or a silicon nitride film mask is used, an additional step of forming the mask is required, as compared with the case where the resist mask is used. However, because etching resistance of the silicon oxide film is high, by using such a mask, deeper etching can be conducted than by using the resist mask at an initial stage.

In addition, in each of the above-described embodiments, as means of etching the silicon, the technology in which the etching gas and the protection film forming gas are alternately rendered in the plasma state is used. However, the etching means is not limited thereto. For example, a method in which a mixture gas of the etching gas and the protection film forming gas is rendered in the plasma state, as disclosed in Japanese Patent Application Laid-Open Publication No. 2004-296474, can be employed as a method of the anisotropic dry etching of the silicon. Although an etching rate in this method is lowered as compared with that in the method in which the above-mentioned gases are merely alternately rendered in the plasma state to be used for etching, this method is effective in that asperities on the sidewall surface are made smaller and the sidewall surface becomes smooth. In addition, instead of C₄F₈ which is the above-mentioned protection film forming gas, C₅F₈ may be used. In addition, it is not necessarily required that each of the above-mentioned etching gas and protection film forming gas is a single gas. For example, the etching gas may contain an oxygen gas or an argon gas in addition to SF₆ and the protection film forming gas may contain an oxygen gas in addition to C₄F₈.

Moreover, although in each of the above-described embodiments, the silicon substrate is subjected to the processes, a target to be subjected to the processes is not limited to the silicon substrate. For example, the present invention is applicable to a substrate including a silicon layer, such as SOI (Silicon on Insulator).

Furthermore, although in each of the above-described embodiments, the ICP (Inductively Coupled Plasma) is used as the plasma generation means, the present invention is not limited thereto. Effects of the present invention can be attained even by using other high density plasma, for example, CCP (Capacitive-Coupled Plasma) or ECR (Electron-Cyclotron Resonance Plasma). As described above, it is intended that all such modifications, alterations, and substitutions be considered to fall within the spirit and scope of the present invention as defined by the appended claims.

## Claims

1. A method for manufacturing a silicon structure having an opening which has a high aspect ratio, the method comprising the steps of:
performing hole etching or trench etching of silicon so as to substantially expose a portion of at least a bottom surface of etched silicon;
forming a silicon oxide film by a CVD method on the silicon structure formed by the step of performing the hole etching or the trench etching;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

2. A method for manufacturing a silicon structure having an opening which has a high aspect ratio, the method comprising the steps of:
performing hole etching or trench etching of silicon by plasma generated by alternately rendering an etching gas and an organic deposit forming gas in a plasma state or generated by mixing the etching gas and the organic deposit forming gas;
etching, by plasma generated by using oxygen or an oxygen-containing gas, an organic deposit on the silicon structure formed by the step of performing the hole etching or the trench etching;
forming a silicon oxide film on the silicon structure by a CVD method after the step of etching the organic deposit;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

3. The method for manufacturing the silicon structure according to claim 1 or claim 2, wherein the step of forming the silicon oxide film and the step of exposing the silicon oxide film to the gas containing the hydrogen fluoride vapor are conducted when an aspect ratio of a hole is greater than or equal to 15.

4. The method for manufacturing the silicon structure according to claim 1 or claim 2, wherein the step of forming the silicon oxide film and the step of exposing the silicon oxide film to the gas containing the hydrogen fluoride vapor are conducted when an aspect ratio of a trench is greater than or equal to 30.

5. The method for manufacturing the silicon structure according to claim 1 or claim 2, wherein the silicon structure which has undergone the hole etching or the trench etching includes a resist mask before the hole etching or the trench etching is initially performed.

6. The method for manufacturing the silicon structure according to claim 1 or claim 2, wherein a shortest width of an entrance of the hole is less than or equal to 30 µm.

7. The method for manufacturing the silicon structure according to claim 1 or claim 2, wherein a shortest width of an entrance of the trench is less than or equal to 15 µm.

8. A system for manufacturing a silicon structure having an opening which has a high aspect ratio, comprising:
a chamber for performing hole etching or trench etching of silicon so as to substantially expose a portion of at least a bottom surface of etched silicon;
a chamber for forming a silicon oxide film by a CVD method on the silicon structure formed performing the hole etching or the trench etching;
a chamber for exposing the silicon oxide film to a gas containing a hydrogen fluoride vapor after forming the silicon oxide film; and
transfer means for transferring the silicon structure to each of the chambers without exposing the silicon structure to outside air.

9. A system for manufacturing a silicon structure having an opening which has a high aspect ratio, comprising:
a chamber for performing hole etching or trench etching of silicon by plasma generated by alternately rendering an etching gas and an organic deposit forming gas in a plasma state or generated by mixing the etching gas and the organic deposit forming gas;
a chamber for etching, by plasma generated by using oxygen or an oxygen-containing gas, an organic deposit on the silicon structure formed by performing the hole etching or the trench etching;
a chamber for forming a silicon oxide film on the silicon structure by a CVD method after etching the organic deposit;
a chamber for exposing the silicon oxide film to a gas containing a hydrogen fluoride vapor after forming the silicon oxide film; and
transfer means for transferring the silicon structure to each of the chambers without exposing the silicon structure to outside air.

10. The system, according to claim 9, for manufacturing the silicon structure having an opening which has a high aspect ratio, wherein the chamber for performing the hole etching or the trench etching is the same as the chamber for etching the organic deposit.

11. A silicon structure having an opening which has a high aspect ratio, formed by the steps of:
performing hole etching or trench etching of silicon so as to substantially expose a portion of at least a bottom surface of etched silicon;
forming a silicon oxide film by a CVD method on the silicon structure formed by the step of performing the hole etching or the trench etching;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

12. A silicon structure having an opening which has a high aspect ratio, formed by the steps of:
performing hole etching or trench etching of silicon by plasma generated by alternately rendering an etching gas and an organic deposit forming gas in a plasma state or generated by mixing the etching gas and the organic deposit forming gas;
etching, by plasma generated by using oxygen or an oxygen-containing gas, an organic deposit on the silicon structure formed by the step of performing the hole etching or the trench etching;
forming a silicon oxide film on the silicon structure by a CVD method after the step of etching the organic deposit;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

13. The silicon structure, according to claim 11 or claim 12, having an opening which has a high aspect ratio,
the silicon structure formed by repeating at least once more the steps of: forming the silicon oxide film; thereafter, exposing the silicon oxide film to the gas containing the hydrogen fluoride vapor; and thereafter, performing the hole etching or the trench etching.

14. A program for manufacturing a silicon structure having an opening which has a high aspect ratio, comprising the steps of:
performing hole etching or trench etching of silicon so as to substantially expose a portion of at least a bottom surface of etched silicon;
forming a silicon oxide film by a CVD method on the silicon structure formed by the step of performing the hole etching or the trench etching;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

15. A program for manufacturing a silicon structure having an opening which has a high aspect ratio, comprising the steps of:
performing hole etching or trench etching of silicon by plasma generated by alternately rendering an etching gas and an organic deposit forming gas in a plasma state or generated by mixing the etching gas and the organic deposit forming gas;
etching, by plasma generated by using oxygen or an oxygen-containing gas, an organic deposit on the silicon structure formed by the step of performing the hole etching or the trench etching;
forming a silicon oxide film on the silicon structure by a CVD method after the step of etching the organic deposit;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

16. A storage medium having stored therein a manufacturing program according to claims 14 or claim 15.

17. A system for manufacturing a silicon structure having an opening which has a high aspect ratio, comprising a controller controlled by using a manufacturing program according to claim 14 or claim 15.

18. A method for manufacturing an etching mask for a silicon structure having an opening which has a high aspect ratio, the method comprising the steps of:
forming a silicon oxide film by a CVD method on a silicon structure which has undergone etching of a hole or etching of a trench and whose silicon of at least a bottom surface of the hole or the trench is substantially exposed; and
exposing the silicon oxide film to a gas containing a hydrogen fluoride vapor after the step of forming the silicon oxide film.

19. A method for manufacturing an etching mask for a silicon structure having an opening which has a high aspect ratio, the method comprising the steps of:
etching an organic deposit, by plasma generated by using oxygen or an oxygen-containing gas, on a silicon structure for which hole etching or trench etching has been performed by plasma generated by alternately rendering an etching gas and an organic deposit forming gas in a plasma state or generated by mixing the etching gas and the organic deposit forming gas;
forming a silicon oxide film on the silicon structure by a CVD method after the step of etching the organic deposit; and
exposing the silicon oxide film to a gas containing a hydrogen fluoride vapor after the step of forming the silicon oxide film.

20. A method for manufacturing an etching mask for a silicon structure having an opening which has a high aspect ratio, the method comprising the steps of:
etching an organic deposit, by plasma generated by using oxygen or an oxygen-containing gas, on a silicon structure for which hole etching or trench etching has been performed by plasma generated by alternately rendering an etching gas and an organic deposit forming gas in a plasma state or generated by mixing the etching gas and the organic deposit forming gas;
forming a silicon oxide film on the silicon structure by a CVD method after the step of etching the organic deposit;
exposing the silicon oxide film to a gas containing a hydrogen fluoride vapor after the step of forming the silicon oxide film; and
repeating at least once more, after a step of performing the hole etching or the trench etching, the steps of etching the organic deposit, of forming the silicon oxide film, and of exposing the silicon oxide film to the gas containing the hydrogen fluoride vapor.

21. The method for manufacturing the etching mask according to claim 18 through claim 20, wherein the step of forming the silicon oxide film and the step of exposing the silicon oxide film to the gas containing the hydrogen fluoride vapor are conducted when an aspect ratio of a hole is greater than or equal to 15.

22. The method for manufacturing the etching mask according to claim 18 through claim 20, wherein the step of forming the silicon oxide film and the step of exposing the silicon oxide film to the gas containing the hydrogen fluoride vapor are conducted when an aspect ratio of a trench is greater than or equal to 30.

23. The method for manufacturing the etching mask according to claim 18 through claim 20, wherein the silicon structure which has undergone the hole etching or the trench etching includes a resist mask before the hole etching or the trench etching is initially performed.

24. The method for manufacturing the etching mask according to claim 18 through claim 20, wherein a shortest width of an entrance of the hole is less than or equal to 30 µm.

25. The method for manufacturing the etching mask according to claim 18 through claim 20, wherein a shortest width of an entrance of the trench is less than or equal to 15 µm.

## Amended claims

### Amended claims under Art. 19.1 PCT

**1.** A method for manufacturing a silicon structure having an opening which has a high aspect ratio, the method comprising the steps of:
performing hole etching or trench etching of silicon so as to substantially expose a portion of at least a bottom surface of etched silicon;
forming a silicon oxide film by a CVD method on the silicon structure formed by the step of performing the hole etching or the trench etching;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

**2.** A method for manufacturing a silicon structure having an opening which has a high aspect ratio, the method comprising the steps of:
performing hole etching or trench etching of silicon by plasma generated by alternately rendering an etching gas and an organic deposit forming gas in a plasma state or generated by mixing the etching gas and the organic deposit forming gas;
etching, by plasma generated by using oxygen or an oxygen-containing gas, an organic deposit on the silicon structure formed by the step of performing the hole etching or the trench etching;
forming a silicon oxide film on the silicon structure by a CVD method after the step of etching the organic deposit;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

**3.** The method for manufacturing the silicon structure according to claim 1 or claim 2, wherein the step of forming the silicon oxide film and the step of exposing the silicon oxide film to the gas containing the hydrogen fluoride vapor are conducted when an aspect ratio of a hole is greater than or equal to 15.

**4.** The method for manufacturing the silicon structure according to claim 1 or claim 2, wherein the step of forming the silicon oxide film and the step of exposing the silicon oxide film to the gas containing the hydrogen fluoride vapor are conducted when an aspect ratio of a trench is greater than or equal to 30.

**5.** The method for manufacturing the silicon structure according to claim 1 or claim 2, wherein the silicon structure which has undergone the hole etching or the trench etching includes a resist mask before the hole etching or the trench etching is initially performed.

**6.** The method for manufacturing the silicon structure according to claim 1 or claim 2, wherein a shortest width of an entrance of the hole is less than or equal to 30 µm.

**7.** The method for manufacturing the silicon structure according to claim 1 or claim 2, wherein a shortest width of an entrance of the trench is less than or equal to 15 µm.

**8.** (Canceled)

**9.** (Canceled)

**10.** (Canceled)

**11.** (Canceled)

**12.** (Canceled)

**13.** (Canceled)

**14.** A program for manufacturing a silicon structure having an opening which has a high aspect ratio, comprising the steps of:
performing hole etching or trench etching of silicon so as to substantially expose a portion of at least a bottom surface of etched silicon;
forming a silicon oxide film by a CVD method on the silicon structure formed by the step of performing the hole etching or the trench etching;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

**15.** A program for manufacturing a silicon structure having an opening which has a high aspect ratio, comprising the steps of:
performing hole etching or trench etching of silicon by plasma generated by alternately rendering an etching gas and an organic deposit forming gas in a plasma state or generated by mixing the etching gas and the organic deposit forming gas;
etching, by plasma generated by using oxygen or an oxygen-containing gas, an organic deposit on the silicon structure formed by the step of performing the hole etching or the trench etching;
forming a silicon oxide film on the silicon structure by a CVD method after the step of etching the organic deposit;
exposing the silicon oxide film to a gas containing a hydrogen fluoride vapor after the step of forming the silicon oxide film; and
performing again the hole etching or the trench etching after the step of exposing the silicon oxide film to the gas containing the hydrogen fluoride vapor.

**16.** A storage medium having stored therein a manufacturing program according to claims 14 or claim 15.

**17.** A system for manufacturing a silicon structure having an opening which has a high aspect ratio, comprising a controller controlled by using a manufacturing program according to claim 14 or claim 15.

**18.** A method for manufacturing an etching mask for a silicon structure having an opening which has a high aspect ratio, the method comprising the steps of:
forming a silicon oxide film by a CVD method on a silicon structure which has undergone etching of a hole or etching of a trench and whose silicon of at least a bottom surface of the hole or the trench is substantially exposed; and
exposing the silicon oxide film to a gas containing a hydrogen fluoride vapor after the step of forming the silicon oxide film.

**19.** A method for manufacturing an etching mask for a silicon structure having an opening which has a high aspect ratio, the method comprising the steps of:
etching an organic deposit, by plasma generated by using oxygen or an oxygen-containing gas, on a silicon structure for which hole etching or trench etching has been performed by plasma generated by alternately rendering an etching gas and an organic deposit forming gas in a plasma state or generated by mixing the etching gas and the organic deposit forming gas;
forming a silicon oxide film on the silicon structure by a CVD method after the step of etching the organic deposit; and
exposing the silicon oxide film to a gas containing a hydrogen fluoride vapor after the step of forming the silicon oxide film.

**20.** A method for manufacturing an etching mask for a silicon structure having an opening which has a high aspect ratio, the method comprising the steps of:
etching an organic deposit, by plasma generated by using oxygen or an oxygen-containing gas, on a silicon structure for which hole etching or trench etching has been performed by plasma generated by alternately rendering an etching gas and an organic deposit forming gas in a plasma state or generated by mixing the etching gas and the organic deposit forming gas;
forming a silicon oxide film on the silicon structure by a CVD method after the step of etching the organic deposit;
exposing the silicon oxide film to a gas containing a hydrogen fluoride vapor after the step of forming the silicon oxide film; and
repeating at least once more, after a step of performing the hole etching or the trench etching, the steps of etching the organic deposit, of forming the silicon oxide film, and of exposing the silicon oxide film to the gas containing the hydrogen fluoride vapor.

**21.** The method for manufacturing the etching mask according to claim 18 through claim 20, wherein the step of forming the silicon oxide film and the step of exposing the silicon oxide film to the gas containing the hydrogen fluoride vapor are conducted when an aspect ratio of a hole is greater than or equal to 15.

**22.** The method for manufacturing the etching mask according to claim 18 through claim 20, wherein the step of forming the silicon oxide film and the step of exposing the silicon oxide film to the gas containing the hydrogen fluoride vapor are conducted when an aspect ratio of a trench is greater than or equal to 30.

**23.** The method for manufacturing the etching mask according to claim 18 through claim 20, wherein the silicon structure which has undergone the hole etching or the trench etching includes a resist mask before the hole etching or the trench etching is initially performed.

**24.** The method for manufacturing the etching mask according to claim 18 through claim 20, wherein a shortest width of an entrance of the hole is less than or equal to 30 µm.

**25.** The method for manufacturing the etching mask according to claim 18 through claim 20, wherein a shortest width of an entrance of the trench is less than or equal to 15 µm.
